# EUROPEAN PATENT SPECIFICATION

(11) **EP 3 864 188 B1**
(45) Date of publication and mention of the grant of the patent: **30.07.2025**
(21) Application number: 19782629.0
(22) Date of filing: 09.10.2019
(51) Int. Cl.: C23C 18/12, C23C 24/08, C23C 28/04

(54) **A HIGHLY CORROSION PROTECTIVE THIN BI-LAYER STACK FOR STEEL**
DÜNNER DOPPELSCHICHTSTAPEL MIT HOHEM KORROSIONSSCHUTZ FÜR STAHL
EMPILEMENT BI-COUCHE MINCE HAUTEMENT PROTECTEUR CONTRE LA CORROSION POUR L'ACIER

(30) Priority: 11.10.2018 EP 18382722
(43) Date of publication of application: 18.08.2021
(73) Proprietor: Fundación Tecnalia Research & Innovation, 20009 Donostia - San Sebastian (ES); ASOCIACIÓN CENTRO DE INVESTIGACIÓN COOPERATIVA EN NANOCIENCIAS "CIC nanoGUNE", 20018 Donosita-San Sebastián, (ES)
(72) Inventor: AGUSTIN SAENZ, Cecilia, 20009 DONOSTIA - SAN SEBASTIÁN (ES); BRUSCIOTTI, Fabiola, 20009 DONOSTIA - SAN SEBASTIÁN (ES); BRIZUELA PARRA, Marta, 20009 DONOSTIA - SAN SEBASTIÁN (ES); KNEZ, Mato, 20018 DONOSTIA (ES); WILLADEAN DUMONT, Jaime, 20018 DONOSTIA (ES)
(74) Representative: ZBM Patents - Zea, Barlocci & Markvardsen
(86) International application number: PCT/EP2019/077381
(87) International publication number: WO 2020/074593

(56) References cited:
- WO-A1-2018/073186
- JP-A- H 024 985
- JP-A- S63 195 283
- US-A1- 2018 029 074

## Description

This application claims the benefit of European Patent Application EP18382722.9 filed on October 11th, 2018.

The present invention relates to a combination of inorganic ceramic materials with sol-gel coating compositions and steel substrates coated with them. In particular, to a bi-layer stack coated steel substrate which comprises an inorganic ceramic layer and a sol-gel layer providing highly corrosion resistant properties. The present invention also relates to a process for its preparation.

### Background Art

Iron and its alloys (i.e. steel) are extensively used in structural applications, e.g. in marine and aircraft sectors and cultural heritage. Carbon steel is the most common form of steel and because of its low cost it is the main material used in construction. Carbon steel has good strength, it is hard, and it can be bent, worked or can be welded into an endless variety of shapes for uses ranging from vehicles (e.g. cars and ships) to building materials. Because of its unique properties such as low cost, high strength, hardness and easy availability, it has wide range of applications in nut bolt, chains, hinges, knives, armour, pipes, and magnets.

While iron and its alloys are useful because of their physical characteristics, they are highly susceptible to corrosion in aggressive environments. Steel, particularly carbon steel, is exposed to aggressive environment under atmospheric condition during its manufacture, processing, storage, or transportation and this can accelerate the degradation of the alloy and the end-products.

Therefore, research efforts have been focused on the development of steel substrates highly resistant to corrosion. A generic way to protect metals/alloys from corrosion is to apply protective films or coatings that allow keeping the desired properties of the substrate. Two appropriate defence strategies to reduce corrosive attack can be envisaged: passive corrosion protection and active corrosion protection. Passive protection is normally provided by a barrier film that prevents contact of corrosive species with the metal/alloy surface and therefore hinders a corrosion process, while active protection refers to the ability to protect the exposed metal/alloy surface (due to defects in the barrier film) by employing inhibitive species that can decrease corrosion activity.

One approach is the use of inorganic oxide coatings, which can provide good protection on metal/alloy substrates. However, these inorganic oxide coatings present some drawbacks: (i) the oxide films are brittle; (ii) cracks appear on the coatings during the thermal treatment; and (iii) it is difficult to achieve a coating thickness higher than 500 nm. In order to undertake this limitation, different techniques to incorporate organic moieties to the coating composition have been accomplished in the state of the art, thus permitting to obtain thicker and more flexible materials. The sol-gel processing has proven to be a promising route due to the ability to combine inorganic and organic moieties at molecular level. Therefore, the application of hybrid inorganic-organic sol-gel coating is able to enhance the passive corrosion protection provided by pure inorganic coatings. Although it is a suitable synthesis route, the sol-gel technique also presents some serious drawbacks, such as the extreme volume shrinkage at the time of gelation, the elimination of the unwanted residuals such as unreacted hydroxyl and alkoxy groups and the presence of pores or vacancies on the coating if it is not treated at temperature as high as needed for their collapse and densification. All of them can compromise the corrosion resistance of the steel.

As a result of the above, from what is known in the art it is derived that there is still the need of providing a steel substrate with a high corrosion resistance.

Document JP H02 4985 relates to a bi-layer coated substrate comprising an inner inorganic ceramic coating and to an external sol-gel layer, wherein the inner layer is thermally sprayed onto the substrate.

Document WO2018/073186 discloses sol-gel coating compositions and methods of making thereof. In accordance with this document, the more suitable methods for the deposition of sol-gel coating involves preferably dry film techniques.

### Summary of Invention

Inventors have found a bi-layer stack composed by an inorganic ceramic coating and a sol-gel coating, that provides excellent anti-corrosion properties to steel substrates. In particular, the inventors have found that the specific combination of an inner inorganic ceramic coating and an external sol-gel coating in the arrangement specified in the present invention results in excellent corrosion resistance, superior to what could be expected from each one of the layers individually. This effect is due to a synergic effect produced between the steel and the two protective layers.

Thus, the specific bi-layer inorganic ceramic and sol-gel coating stack allows the preparation of a protective system having the appropriate surface morphology and the minimal thickness that contributes to reduce the corrosion rate of steel and therefore enhancing its resistance to corrosion.

Furthermore, inventors have also found that the bi-layer formed by inorganic ceramic and sol-gel stacked for coating steel has an improved adhesion capability. It means that the bi-layer stack has excellent adhesion to steel and also to the most commonly used primers, paints and top-coats that overcoat the sol-gel corrosion protection coatings.

Thus, a first aspect of the present invention relates to a process for preparing a bi-layer coated steel substrate comprising:
either an inner inorganic ceramic layer and an external sol-gel layer, wherein the process comprises:
a) firstly, depositing an inorganic ceramic coating composition over a steel substrate to obtain a steel substrate coated by the inorganic ceramic mono-layer;
b) secondly, depositing a sol-gel coating composition selected from the group consisting of sol1, sol2 and sol3 over the coated steel substrate obtained in step a) to obtain the bi-layer coated steel substrate;
and c) thirdly, curing the coating obtained in step b);
and optionally; the process further comprises an additional step d) which comprises depositing one or more additional coatings over the bi-layer coated steel substrate obtained in step c);
and optionally; the process further comprises an additional step which comprises depositing one or more additional coatings over the bi-layer coated steel substrate obtained in the third step;
wherein:
   the sol1 is a sol-gel coating composition obtainable by a process b1) which comprises:
   b1') preparing a first mixture which comprises at least one alkoxide selected from the group consisting of a metal alkoxide, a semimetal alkoxide, an organo-silicon alkoxide and a mixture thereof; and optionally at least one (C₁-C₈)alcohol;
   b1") preparing a second mixture with an aqueous solution of at least one acid catalyst having a pH lower than 5; and optionally: at least one organic precursor, at least one (C₁-C₈) alcohol, at least one polymerization initiator or a mixture thereof; and
   b1‴) adding the second mixture obtained in step b1") to the resulting mixture of step b1'); and stirring the resulting mixture at a temperature from 15 °C to 45 °C for an appropriate period of time to obtain the sol1; and
   b1ʺʺ) ageing the resulting mixture by stirring at a temperature from 15 °C to 30 °C for a period of time from 24 h to 72 h;
   the sol2 is a sol-gel coating composition obtainable by a process b2) which comprises:
      b2') preparing a mixture which comprises at least one metal alkoxide; and optionally one or more (C₁-C₈) alcohol under an inert and dry atmosphere;
      b2") adding a complexing agent to the resulting mixture obtained in step b2'); and stirring the resulting mixture for an appropriate period of time;
      b2‴) adding an aqueous solution of at least one acid catalyst having a pH lower than 7 to the resulting mixture obtained in step b2") and stirring the resulting mixture at a temperature from 15 °C to 30 °C for an appropriate period of time to obtain the sol2, and
      b2ʺʺ) ageing the resulting mixture by stirring at a temperature from 15 °C to 30 °C for a period of time from 24 h to 72 h;
         and
      the sol3 is a sol-gel coating composition obtainable by a process which comprises mixing the sol1 obtained in step b1‴) or step b1ʺʺ) with the sol2 obtained in step b2‴) or step b2ʺʺ), and ageing the resulting mixture by stirring at a temperature from 15 °C to 30 °C for a period of time from 24 h to 72 h.

Particularly, the present invention relates to a process for preparing a bi-layer coated steel substrate comprising: an inner inorganic ceramic layer and an external sol-gel layer, wherein the process comprises:
a) firstly, depositing an inorganic ceramic coating composition over a steel substrate to obtain a steel substrate coated by the inorganic ceramic mono-layer;
b) secondly, depositing a sol-gel coating composition selected from the group consisting of sol1, sol2 and sol3 over the coated steel substrate obtained in step a) to obtain the bi-layer coated steel substrate;
and c) thirdly, curing the coating obtained in step b);
and optionally; the process further comprises an additional step d) which comprises depositing one or more additional coatings over the bi-layer coated steel substrate obtained in step c);
wherein:
   the sol1 is a sol-gel coating composition obtainable by a process b1) which comprises:
   b1') preparing a first mixture which comprises at least one alkoxide selected from the group consisting of a metal alkoxide, a semimetal alkoxide, an organo-silicon alkoxide and a mixture thereof; and optionally at least one (C₁-C₈)alcohol;
   b1") preparing a second mixture with an aqueous solution of at least one acid catalyst having a pH lower than 5; and optionally: at least one organic precursor, at least one (C₁-C₈) alcohol, at least one polymerization initiator or a mixture thereof; and
   b1‴) adding the second mixture obtained in step b1") to the resulting mixture of step b1'); and stirring the resulting mixture at a temperature from 15 °C to 45 °C for an appropriate period of time to obtain the sol1; and
   b1ʺʺ) ageing the resulting mixture by stirring at a temperature from 15 °C to 30 °C for a period of time from 24 h to 72 h;
   the sol2 is a sol-gel coating composition obtainable by a process b2) which comprises:
      b2') preparing a mixture which comprises at least one metal alkoxide; and optionally one or more (C₁-C₈) alcohol under an inert and dry atmosphere;
      b2") adding a complexing agent to the resulting mixture obtained in step b2'); and stirring the resulting mixture for an appropriate period of time;
      b2‴) adding an aqueous solution of at least one acid catalyst having a pH lower than 7 to the resulting mixture obtained in step b2") and stirring the resulting mixture at a temperature from 15 °C to 30 °C for an appropriate period of time to obtain the sol2, and
      b2ʺʺ) ageing the resulting mixture by stirring at a temperature from 15 °C to 30 °C for a period of time from 24 h to 72 h;
         and
      the sol3 is a sol-gel coating composition obtainable by a process which comprises mixing the sol1 obtained in step b1‴) or step b1ʺʺ) with the sol2 obtained in step b2‴) or step b2ʺʺ), and ageing the resulting mixture by stirring at a temperature from 15 °C to 30 °C for a period of time from 24 h to 72 h;
      wherein step a) is performed using a technique selected from the group consisting of atomic layer deposition, chemical vapour deposition and physical vapour deposition.

A second aspect of the present invention relates to a bi-layer coated steel substrate comprising an inner inorganic ceramic layer and an external sol-gel layer obtainable by the process as defined in the first aspect of the invention.

### Brief Description of Drawings

Figure 1 shows the Fourier transform infrared (FTIR) spectrum of the sol-gel coating composition of Example 1 deposited over a KBr plate. The spectrum expresses the transmittance (%) versus wavelength (cm⁻¹).
Figure 2 shows the survey spectrum acquired by X-ray Photoelectron Spectroscopy (XPS) of the sol-gel coating composition of Example 1. The pattern expresses intensity (counts) versus binding energy (eV).

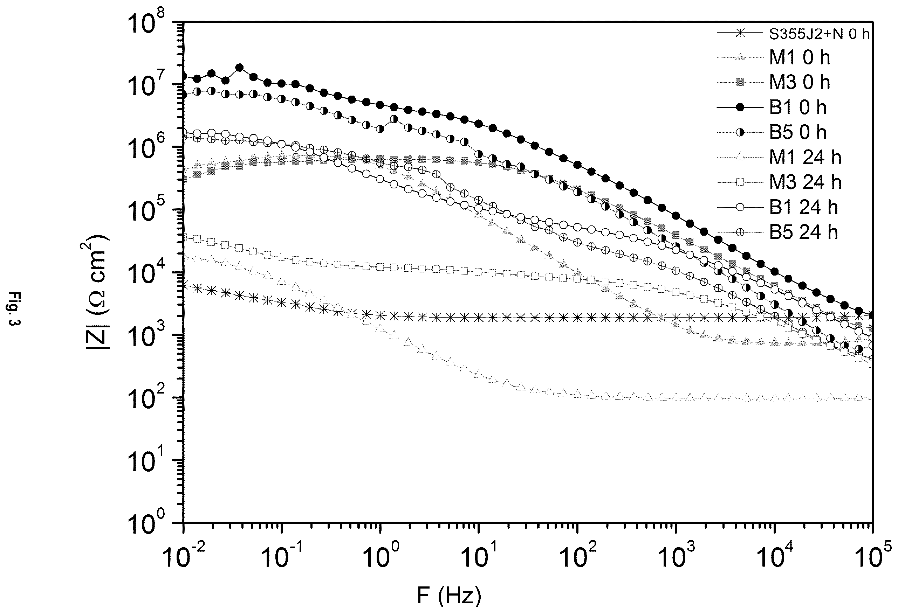

Figure 3 depicts the impedance modulus (|Z| (Ω cm²)) measured in the range of frequencies (F) between 10⁻² -10⁵ Hz. Spectra of the bi-layer coated steel substrates B1 (inner inorganic ceramic layer and external sol-gel layer) and B5 (inner sol-gel layer and external inorganic ceramic layer - not according to the invention), and comparative mono-layer (inorganic oxide) M1 and comparative mono-layer (sol-gel) M3 taken just after immersion in NaCl 0.005M (time 0 h) and after 24 h of immersion are represented. Impedance at the beginning of immersion of the bare S355J2+N steel is also included as baseline.

### Detailed description of the invention

All terms as used herein in this application, unless otherwise stated, shall be understood in their ordinary meaning as known in the art. More specific definitions for certain terms as used in the present application are as set forth below and are intended to apply uniformly throughout the specification and claims unless an otherwise expressly set out definition provides a broader definition.

For purposes of the present invention, the given ranges include both the lower and the upper end-points. Ranges such as temperatures, times, and the like, should be considered approximate, unless specifically stated.

For the purpose of the invention, the term "sol-gel" or "solution sol-gel" or "SG" process have the same meaning and are used interchangeably. They refer to a chemical process that is used for the synthesis of single- or multiple-component materials, including glasses, in the form of thin solid films, ultrafine powders, high surface area porous materials, dense abrasive minerals, and continuous ceramic and glass fibres. In particular, a sol-gel coating is prepared by a sol-gel process that involves the preparation of one or more precursor mixtures (also called "sol"), which is converted into intermediate product (also called "gel") and thereof into a specified material by a process that may involve chemical reactions, product forming, gelification, drying, and curing.

The term "sol" refers to either a dispersion of colloidal particles of one phase in a fluid medium or a solution prepared by hydrolysis and polycondensation of metalorganic derivatives compounds or inorganic salts in alcoholic solution. The term "gel" refers to a material consisting of a three-dimensional network of a solid phase interwoven with an entrapped and immobilized continuous liquid phase.

The term "alkyl" refers to a saturated straight, or branched hydrocarbon chain that contains the number of carbon atoms specified in the description or claims. Examples include, among others, the group methyl, ethyl, propyl, isopropyl, butyl, isobutyl, sec-butyl, tert-butyl, n-pentyl, and n-hexyl.

The term "(C₁-C₁₂) alkylene" refers to a saturated straight or branched bivalent aliphatic hydrocarbon chain that contains the number of carbon atoms specified in the description or claims. Examples include, among others, the group methylene, ethylene and propylene.

The term "(C₂-C₁₄)alkenyl" refers to a saturated straight, or branched alkyl chain that contains from 2 to 14 carbon atoms and one or more double bonds. Examples include, among others, ethenyl, 1-propen-1-yl, 1-propen-2-yl, 3-propen-1-yl, 1-buten-1-yl, 1-buten-2-yl, 3-buten-1-yl, 3-buten-2-yl, 2-buten-1-yl, 2-buten-2-yl, 2-methyl-1-propen-1-yl, 2-methyl-2-propen-1-yl, 1,3-butadien-1-yl, 1,3-butadien-2-yl, and 2-hexenyl.

The term "(C₂-C₁₄) alkynyl" refers to a saturated straight, or branched alkyl chain that contains from 2 to 14 carbon atoms and one or more triple bonds. Examples include, among others, ethynyl, 1-propynyl, 2-butynyl, 1,3-butadinyl, 4-pentynyl, and 1-hexynyl.

The term "(C₅-C₆)aryl" refers to a 5 to 6 membered ring, saturated, partially or totally unsaturated, optionally bridged or fused to a 5 to 6 membered ring; the members of the rings being independently selected from C, CH, CH₂, O, N, NH, and S; being one or more of the hydrogen atoms of the members optionally substituted by a radical selected from the group consisting of (C₁-C₆)alkyl, (C₁-C₆)haloalkyl, halogen, (C₁-C₆)alkoxy, (C₁-C₆)alkylcarbonyl, (C₁-C₆)alkyloxycarbonyl, nitro and cyano.

The term "halogen" refers to fluorine, chlorine, bromine and iodine.

The term "room temperature" refers to a temperature from 20 °C to 25 °C.

The terms "percentage (%) by weight" or "% by weight" are used interchangeably and they refer to the percentage of each component in relation to the total weight of the composition.

The term "metal alkoxide" refers to a compound characterized by a metal central atom that forms covalent bonds with oxygen-carbon, namely metal-oxygen-carbon bonds. The term "metal atom" refers to elements that form materials in which the valence and the conduction band is overlapped. It refers to chemical elements defined as metal in the periodic table of elements. Metallic elements are subdivided in alkali metals, alkaline earth metals, transition metals, post-transition metals, lanthanides and actinides. Examples of metals appropriate for the present invention include, without limitation, Al, Ti, Zr and Y.

The term "semimetal alkoxide" refers to a compound characterized by a semimetal central atom that forms covalent bonds with oxygen-carbon, namely semimetal-oxygen-carbon bonds. The term "semimetal atom" refers to chemical elements defined as "metalloid" in the periodic table of elements. Examples of semimetals appropriate for the present invention include, without limitation, Si, Ge, B, As, Sb, Te, Po and At.

The term "organo-silicon alkoxide" refers to a semimetal organic compound in which the central atom is silicon that forms two types of covalent bonding systems. One of them is silicon-oxygen-carbon and the other is silicon-carbon.

The terms "coating" or "layer" have the same meaning and are used interchangeably. They refer to the surface that remains after the deposition of a "coating composition" directly onto the bare surface of a substrate or alternatively onto a substrate which already has one or more layers.

For the purposes of the invention the expressions "obtainable", "obtained" and equivalent expressions are used interchangeably, and in any case, the expression "obtainable" encompasses the expression "obtained".

As mentioned above, an aspect of the present invention refers to a process for preparing a bi-layer coated steel substrate comprising an inorganic ceramic layer and a sol-gel layer.

The first alternative process for preparing a bi-layer coated steel substrate of the present invention comprises preparing a bi-layer coated steel substrate comprising an inner inorganic ceramic layer and an external sol-gel layer, wherein the process comprises:
a) firstly, depositing an inorganic ceramic coating composition over a steel substrate to obtain a steel substrate coated by the inorganic ceramic mono-layer;
b) secondly, depositing a sol-gel coating composition selected from the group consisting of sol1, sol2 and sol3 over the coated steel substrate obtained in step a) to obtain the bi-layer coated steel substrate;
and c) thirdly, curing the coating obtained in step b);
and optionally; the process further comprises an additional step d) which comprises depositing one or more additional coatings over the bi-layer coated steel substrate obtained in step c);
wherein:
   the sol1 is a sol-gel coating composition obtainable by a process b1) which comprises:
   b1') preparing a first mixture which comprises at least one alkoxide selected from the group consisting of a metal alkoxide, a semimetal alkoxide, an organo-silicon alkoxide and a mixture thereof; and optionally at least one (C₁-C₈)alcohol;
   b1") preparing a second mixture with an aqueous solution of at least one acid catalyst having a pH lower than 5; and optionally: at least one organic precursor, at least one (C₁-C₈) alcohol, at least one polymerization initiator or a mixture thereof; and
   b1‴) adding the second mixture obtained in step b1") to the resulting mixture of step b1'); and stirring the resulting mixture at a temperature from 15 °C to 45 °C for an appropriate period of time to obtain the sol1; and b1ʺʺ) ageing the resulting mixture by stirring at a temperature from 15 °C to 30 °C for a period of time from 24 h to 72 h;
   the sol2 is a sol-gel coating composition obtainable by a process b2) which comprises:
      b2') preparing a mixture which comprises at least one metal alkoxide; and optionally one or more (C₁-C₈) alcohol under an inert and dry atmosphere;
      b2") adding a complexing agent to the resulting mixture obtained in step b2'); and stirring the resulting mixture for an appropriate period of time;
      b2‴) adding an aqueous solution of at least one acid catalyst having a pH lower than 7 to the resulting mixture obtained in step b2") and stirring the resulting mixture at a temperature from 15 °C to 30 °C for an appropriate period of time to obtain the sol2, and
      b2ʺʺ) ageing the resulting mixture by stirring at a temperature from 15 °C to 30 °C for a period of time from 24 h to 72 h;
         and
      the sol3 is a sol-gel coating composition obtainable by a process which comprises mixing the sol1 obtained in step b1‴) or step b1ʺʺ) with the sol2 obtained in step b2‴) or step b2ʺʺ), and ageing the resulting mixture by stirring at a temperature from 15 °C to 30 °C for a period of time from 24 h to 72 h.

For the purposes of the invention, the term "steel substrate" refers to any material made or covered by a layer of any alloy of iron and carbon and another elements such as for example manganese, nickel, chromium, molybdenum, boron, titanium, vanadium, tungsten, cobalt, niobium, phosphorus, sulphur or silicon. Examples of steel include, without limitation, carbon steel, alloy steel, stainless steel, tool steel, structural steel, cast steel, nickel steel, nickel-chromium steel, molybdenum steel, chromium steel, chromium-vanadium steel, tungsten-chromium steel, nickel-chromium-molybdenum steel, silicon-manganese steel, tungsten steel, mild steel, low-carbon steel, medium-carbon steel, high-carbon steel, ultra-high-carbon steel, low-alloy steel, high-alloy steel, austenitic stainless steel, ferritic stainless steels, martensitic stainless steels, duplex stainless steel, high-speed steel, high-strength steel, crucible steel, Damascus steel, end of steel, magnet steel, maraging steel, pedal steel guitar, rolled-steel joist, steel band, steel blue, steel engraving, steel grey, steel guitar or steel wool. Steel substrates can exhibit any particular microstructure such as ferritic, pearlitic or martensitic; and they can be submitted to heat treatment by known processes such as annealing, quenching or tempering. Steel substrates can be produced by any known method in the state of the art, such as continuous cast and electric furnace. Steel substrates finishing can be any known method in the state of the art such as cold rolled, hot rolled, cold drawn or cold finished, etc. Steel substrates can be in any form or shape such as bar, rod, tube, pipe, plate, sheet or structural.

In an embodiment, the steel substrate is a substrate selected from the group consisting of carbon steels (also named plain carbon steels) selected from low-carbon steel (having lower than 0.2% by weight of carbon content), medium-carbon steel (having between 0.2-0-5 % by weight of carbon content) and high-carbon steel (having more than 0.5% by weight of carbon content); low-alloy steels (alloys with not more than 8% by weight of alloying elements) and high-alloy steels (alloys with more than 8% by weight of alloying elements) according to American Iron and Steel Institute (AISI) [ASM Handbook Volume 1, Properties and Selection: Irons, Steels and High Performance Alloys].

In an embodiment, the steel substrate is a carbon steel substrate selected from the group consisting of low-carbon steel, medium-carbon steel and high-carbon steel. Particularly, the steel is a medium-carbon steel, and more particularly, the steel is designated S355J2+N according to EN10025 standard.

Further, for the purposes of the invention, the term "inorganic ceramic composition" refers to solid materials that comprises an inorganic compound having one or more metal, non-metal or metalloid atoms primarily held in ionic and covalent network as oxide, nitride, carbide, sulphide, phosphide or fluoride.

In an embodiment, the process for preparing a bi-layer coated steel substrate, comprising an inner inorganic ceramic layer and an external sol-gel layer, firstly comprises performing step a) by depositing an inorganic ceramic coating composition over a steel substrate to obtain a steel substrate coated by an inorganic ceramic mono-layer.

In an embodiment, in step a) of the process for preparing a bi-layer coated steel substrate of the invention the inorganic ceramic coating composition comprises one or more metal or semimetal oxide; metal or semimetal nitride; metal or semimetal carbide; metal or semimetal sulphide; metal or semimetal phosphide; metal or semimetal fluoride and mixture thereof.

In an embodiment, in step a) of the process for preparing a bi-layer coated steel substrate of the invention the inorganic ceramic coating composition comprises one or more metal or semimetal oxide; metal or semimetal nitride; metal or semimetal carbide; metal or semimetal sulphide; metal or semimetal phosphide; metal or semimetal fluoride wherein the metal atom is selected form the group consisting of Al, Ti, Zr, Y and the semimetal atom is selected from the group consisting of Si, Ge, B and a mixture thereof.

In an embodiment, in step a) of the process for preparing a bi-layer coated steel substrate of the invention the inorganic ceramic coating composition comprises one or more metal or semimetal oxides. In an embodiment, in step a) of the process for preparing a bi-layer coated steel substrate of the invention the inorganic ceramic coating composition comprises one or more metal oxide having a metal atom selected from the group consisting of Al, Ti, Zr, Y and a mixture thereof; particularly Al.

In an embodiment, in step a) of the process for preparing a bi-layer coated steel substrate of the invention the inorganic ceramic coating composition comprises one or more semimetal oxide having a metal atom selected from the group consisting of Si, Ge, B and a mixture thereof; particularly Si. In an embodiment, in step a) of the process for preparing a bi-layer coated steel substrate of the invention the inorganic ceramic coating composition is selected from the group consisting of Al₂O₃, B₂O₃, SiO₂, TiO₂, ZrO₂ Y₂O₃, GeO₂, CrOₓ, FeOₓ, VOₓ, MnOₓ, CoOₓ, SnO₂, ZnO, MgO, AIN, AlP, BN, Si₃N₄, SiC, TiN, GaN, GaP, ZnF, ZnS, MnS, AlₓSi_{y}O_{z}, AlₓTi_{y}O_{z}, AlₓCr_{y}O_{z}, SiₓTi_{y}O_{z}, TiₓZr_{y}O_{z}, BₓP_{y}O_{z} and a mixture thereof; particularly Al₂O₃.

Step a) can be performed using the known techniques of the state of the art for depositing an inorganic ceramic coating over a substrate. In an embodiment, step a) is performed by depositing the inorganic ceramic layer over a steel substrate using a technique selected from the group consisting of atomic layer deposition (ALD), chemical vapour deposition (CVD), physical vapour deposition (PVD), . In an embodiment, step a) of the process for preparing a bi-layer coated steel substrate of the invention is performed using a technique selected from the group consisting of atomic layer deposition (ALD), chemical vapour deposition (CVD) and physical vapour deposition (PVD). In an embodiment, step a) of the process for preparing a bi-layer coated steel substrate of the invention is performed by Atomic Layer Deposition (ALD).

For the purpose of the invention, the term "Atomic Layer Deposition (ALD)" or "Atomic Layer Epitaxy (ALE)" or "Atomic Layer Evaporation (ALE)" or "Atomic Layer Growth (ALG)" or "Chemical Assembly" or "Molecular Layer Deposition (MLD)" or "Molecular Lamination" or "Molecular Layer Epitaxy (MLE)" or "Molecular Layering (ML)" or "Molecular Stratification" have the same meaning and are used interchangeably. They refer to a method for the deposition of inorganic ceramic coatings over a substrate based on sequential alternating pulses of gaseous chemical precursors that react with the substrate, leading to a conformal thin film. Thus, atomic layer deposition (ALD) of films and coatings involve a plurality of consecutive vapor phase deposition cycles based on self-limited reactions which sequentially on a surface substrate non-necessary heated, conducted in a deposition chamber at vacuum or atmospheric pressure. The term "atomic layer deposition" encompasses the following method 'plasma enhanced atomic layer deposition' (PEALD).

As used herein, the term "atomic layer deposition" refers to a deposition process in which a plurality of consecutive vapor phase deposition cycles based on self-limited reactions is sequentially conducted in a deposition chamber. Commonly, ALD consists of sequential alternating pulses of gaseous chemical precursors that react with the substrate. These individual gas-surface reactions are called 'half-reactions'. During each 'half-reaction', the 'first chemical precursor' is pulsed into a chamber under vacuum (<1.5 bar) or atmospheric pressure for a designated amount of time to allow it to react with the surface through a self-limiting process that forms a chemisorbed (sub)mono-layer. Subsequently, the chamber is purged with an 'inert carrier gas' to remove excess reaction gas, excess second chemical precursor, and by-products. A 'second chemical precursor' or 'counter-reactant precursor' is pulsed and purged, which reacts with the chemisorbed (sub)mono-layer of the first chemical creating up to one layer of the 'final material'. Excess reaction gas, excess second chemical precursor, and by-products are removed from the deposition chamber. By repeating the ALD pulses, (sub)mono-layers of the 'first chemical precursor' react with the 'counter-reactant precursor' until the appropriate thickness of the 'final material' is achieved. By way of example, the first chemical precursor may be titanium tetrachloride (TiCl₄) and the second chemical precursor may be water (H₂O). In contrast to their CVD analogs, the ALD procedures feature alternating exposure of chemical precursors to react to form the desired material, often at significantly lower temperatures. These processes are conducted at temperatures below 350 °C.

In an embodiment, step a) of the process for preparing a bi-layer coated steel substrate of the invention is performed by introducing a metal substrate in a reactor and exposing it to alternating vapours in an evacuated reaction chamber to form an inorganic ceramic coating composition (also named inorganic ceramic material) by an ALD process which comprises:
a1) introducing a metal substrate in a reactor at a base pressure below 1.5 mbar;
a2) introducing a 'first chemical precursor' pulse from 1 to 500 ms;
a3) introducing an 'inert carrier gas' pulse from 0.5 to 5 s;
a4) introducing a 'counter-reactant precursor' pulse from 1 to 500 ms; and
a5) introducing an 'inert carrier gas' pulse from 0.5 to 5 s.

In an embodiment, in step a) of the process for preparing a bi-layer coated steel substrate of the invention, the 'first chemical precursor' of step a2) is selected from the group consisting of metal or semimetal halide, metal or semimetal hydride, metal or semimetal (C₁-C₆) alkyl, metal or semimetal cyclopentadienyl, metal or semimetal β-diketonate, metal or semimetal alkoxide, metal or semimetal amide, and metal or semimetal amidinate.

In an embodiment, in step a) of the process for preparing a bi-layer coated steel substrate of the invention, the 'first chemical precursor' of step a2) is a metal or semimetal halide of formula M1L1ₙ₁ wherein M1 is a metal or a semimetal as defined above and L1 is selected from the group consisting of fluoride, chloride, bromide and iodide and n1 is an integer from 1 to 4.

In an embodiment, in step a) of the process for preparing a bi-layer coated steel substrate of the invention, the 'first chemical precursor' of step a2) is a metal or semimetal (C₁-C₆)alkyl of formula M2L2ₙ₂ wherein LM2 is a metal or a semimetal as defined above and L2 is selected from the group consisting of methyl, ethyl, n-propyl, isopropyl, allyl, n-butyl, isobutyl, tert-butyl and neopentyl, and n2 is an integer from 1 to 4.

In an embodiment, in step a) of the process for preparing a bi-layer coated steel substrate of the invention, the 'first chemical precursor' of step a2) is a metal or semimetal cyclopentadienyl of formula M3L3ₙ₃ wherein M3 is a metal or a semimetal as defined above and L3 is selected form the group consisting of cyclopentadienyl, methyl cyclopentadienyl, pentamethyl cyclopentadienyl, ethyl cyclopentadienyl, tri-isopropyl cyclopentadienyl and trimethylsilyl cyclopentadienyl, and n3 is an integer from 1 to 4.

In an embodiment, in step a) of the process for preparing a bi-layer coated steel substrate of the invention, the 'first chemical precursor' of step a2) is a metal or semimetal alkoxide of formula M4(OR)ₙ₄ wherein M4 is a metal or a semimetal as defined above, R is selected from methyl, ethyl, n-propyl, isopropyl, allyl, n-butyl, isobutyl, tert-butyl and neopentyl and n4 is an integer from 1 to 4.

In an embodiment, in step a) of the process for preparing a bi-layer coated steel substrate of the invention, the 'first chemical precursor' of step a2) is a metal or semimetal β-diketonate of formula M5L5ₙ₅ wherein M5 is a metal or a semimetal as defined above, L5 is selected from the group consisting of acetylacetonate and tetramethyl heptanedionate.

In an embodiment, in step a) of the process for preparing a bi-layer coated steel substrate of the invention, the 'first chemical precursor' of step a2) is selected from the group consisting of TiCl₄, ZrCl₄, AlCl₃, SiCl₄, AlBr₃, BCl₃, BBr₃, trimethylaluminum (TMA), triethylaluminum, tripropylaluminum, triisopropylaluminum, trimethylboron, and trimethylborate; particularly trimethylaluminum (TMA).

In an embodiment, in step a) of the process for preparing a bi-layer coated steel substrate of the invention, the 'counter-reactant precursor' of step a4) is selected from the group consisting of H₂O, O₃, O₂, H₂O₂, O^{•} from a plasma source, NO₂, NH₃, NO₂, N_{2 h4}, H₂S, H₂Se, SiCl₄, a metal or semimetal alkoxide of formula M4(OR)ₙ₄ as defined above, tetraethylorthosilicate, Si_{2 h6}, AlCl₃, aluminium isopropoxide, TiCl₄, titanium tetrapropoxide, titanium tetraisopropoxide, ZrCl₄, zirconium tetrapropoxide, zirconium tetraisopropoxide, CrO₂Cl₂, POCl₃; particularly H₂O, more particularly demineralized water.

In an embodiment, in step a) of the process for preparing a bi-layer coated steel substrate of the invention, the 'inert carrier gas' of steps a3) and a5) is selected from the group consisting of N₂, Ar or a mixture thereof; particularly N₂.

Particularly, step a) is performed by introducing a metal substrate in a commercial reactor (Beneq TFS200) and exposing it to alternating vapours of the 'first chemical precursor' trimethylaluminum (TMA) and the 'counter-reactant precursor' (demineralized) H₂O in an evacuated reaction chamber. The base pressure of the chamber is 0.5 mbar and the precursor pulsing sequence is 250 ms pulse of TMA, 1.5 s 'inert carrier gas' (N₂) purge to remove excess TMA from the chamber, 2.5 ms pulse of H₂O vapour, and 2.5 s 'inert carrier gas' (N₂) purge to remove reaction by-products and excess H₂O.

For the purpose of the invention, the term "Physical Vapor Deposition" and the abbreviature "PVD" have the same meaning and are used interchangeably. They refer to a method for the deposition of inorganic ceramic coatings over a substrate based on the vaporization of a solid through physical ejection of atoms or molecules into a low pressure vapor or plasma. The vapor or plasma consist of neutral or ionic species that condensates onto a substrate. Thus, physical vapor deposition (PVD) of films involves a process in which the material goes from a condensed phase to a vapor phase and then back to a thin film condensed phase. The term "physical vapor deposition" encompasses the following methods "DC-pulse magnetron sputtering", "DC magnetron sputtering", "RF magnetron sputtering", "DC-pulse reactive magnetron sputtering", "DC reactive magnetron sputtering", "RF reactive magnetron sputtering", "High Power Impulse Magnetron Sputtering (HIPIMS)", "thermal evaporation physical vapor deposition", "electron beam evaporation physical vapor deposition", "filtered and unfiltered cathodic arc physical vapor deposition" and "pulsed laser physical vapor deposition".

As used herein, the term "physical vapor deposition" refers to a variety of methods to deposit thin films by the condensation of a vaporized form of a solid material onto a substrate. The common feature of PVD techniques is the vaporization of a solid through physical ejection of atoms or molecules into a low pressure vapor or plasma. The vapor or plasma consist of neutral or ionic species that condensates onto a substrate. Adding a reactive gas, e.g., N₂ or O₂, allows the formation of nitride or oxide compounds, respectively. PVD techniques encompass a vast array of different ways of vaporizing the source material: thermal evaporation, electron beam evaporation, different kinds of sputtering such as DC, pulsed DC, and RF magnetron sputtering, high power impulse magnetron sputtering (HPIMS) techniques, filtered and unfiltered cathodic arc deposition, and pulsed laser deposition. The substrate, which is the object to be coated with the vaporized sputtered species, could either be at grounded, floating or biased potential. This will greatly influence the properties of the resulting coating. A typical PVD process is carried out in vacuum. The most important steps involved in a PVD process are:
- Evaporation: a target (typically a metal) consisting of the material to be deposited is bombarded by a high-energy source (beam of electrons or ions). Atoms are dislodged from the target surface, so they are vaporized.
- Transport: the vaporized atoms travel from the target to the substrate to be coated. In some applications, coatings will consist of, for example, metal oxides, nitrides or carbides. In such cases, the metal atoms evaporated from the target will then react with the appropriate gas during the transport stage. For the above examples, the reactive gases may be oxygen, nitrogen and methane. However, when the coating only consists of the target material, these reaction processes during transport will not occur.
- Condensation: the coating builds up at the surface of the substrate. This is the deposition of the coating. Depending on the actual process, some reactions between the target material and the reactive gases may also take place at the substrate surface simultaneously with the deposition process.

In an embodiment, step a) of the process for preparing a bi-layer coated steel substrate of the invention is performed by introducing a metal substrate in a chamber and exposing it to vaporized ionized metal and/or metal oxide under vacuum to form an inorganic ceramic coating composition (also named inorganic ceramic material) by a PVD process which comprises:
a'1) introducing a metal substrate and metal/ceramic targets (precursors) in a chamber at a base pressure below 2x10⁻⁵ mbar;
a'2) resistive heating of the chamber to arrive up to temperature between 200-1000 °C;
a'3) metal substrate etching with Ar flow by negative polarization of substrates (optional)
a'4) coating deposition:
   a'4.1) introducing a flow of Ar and reactive O₂ gas
   a'4.2) applying negative polarization on metal targets
   a'4.3) applying negative polarization of substrates (optional)
   a'4.4) controlling the coating growth rate by time deposition

For the purpose of the invention, the term "Chemical Vapor Deposition" and the abbrevature "CVD" have the same meaning and are used interchangeably. They refer to a method for the deposition of inorganic ceramic coatings over a substrate which involve reactions which transform gaseous molecules, called precursors, into a solid material in the form of a thin film or powder on the surface of a heated-substrate. Thus, chemical vapor deposition (CVD) of films and coatings involves the chemical reactions of gaseous reactants on or near the vicinity of a heated substrate surface. The term "chemical vapor deposition" encompasses the mehods "thermal chemical vapor deposition", "atmospheric pressure chemical vapor deposition", "low pressure chemical vapor deposition", "laser chemical vapor deposition", "photochemical vapor deposition", "chemical vapor infiltration", "chemical beam epitaxy", "plasma-assisted chemical vapor deposition" and "plasma-enhanced chemical vapor deposition (PECVD)"

As used herein, the term "chemical vapor deposition" refers to a variety of processes to deposit films that involve reactions which transform gaseous molecules, called precursors, into a solid material in the form of a thin film or powder on the surface of a substrate. The main difference between CVD and PVD is that the precursors are solid in PVD, with the material to be deposited being vaporized from a solid target and deposited onto the substrate. In a typical CVD process, the substrate is exposed to one or more volatile precursors, which react and/or decompose on the substrate surface to produce the desired deposit. There are several types of CVD processes, including atmospheric pressure chemical vapor deposition, metal-organic chemical vapor deposition, low pressure chemical vapor deposition, laser chemical vapor deposition, photochemical vapor deposition, chemical vapor infiltration, chemical beam epitaxy, plasma-assisted chemical vapor deposition and plasma-enhanced chemical vapor deposition. One important difference between CVD processes is the way in which energy is delivered to the reactor: thermal energy, photo energy, and so on. Frequently, volatile by-products are also produced, which are removed by gas flow through the reaction chamber. In most CVD techniques, the temperature of the substrate is a critical issue. Precursor gases (often diluted in carrier gases) are delivered into the reaction chamber at approximately ambient temperatures. As they pass over or come into contact with a heated substrate, they react or decompose forming a solid phase which is deposited onto the substrate. Therefore, the substrate temperature is critical and influence what reactions will take place. The temperature range for CVD process is 500-1200 °C or, occasionally, slightly higher. The process steps involved in CVD are:
- Transport of precursor molecules into the reactor.
- Diffusion of precursor molecules to the surface.
- Adsorption of precursor molecules to the surface.
- Reactions at the surface: decomposition of precursor molecules on the surface and incorporation into a solid coating.
- Recombination of molecular by-products and desorption into the gas phase.

In an embodiment, the process for preparing a bi-layer coated steel substrate of the invention comprises repeating step a) until having a thickness of the inorganic ceramic layer deposited over the steel substrate from 50 nm to 4 µm; particularly from 50 nm to 3 µm. In an embodiment, the process for preparing a bi-layer coated steel substrate of the invention comprises repeating step a) until having a thickness of the inorganic ceramic layer deposited over the steel substrate from 50 nm to 300 nm; more particularly from 50 nm to 200 nm. In an embodiment, the process for preparing a bi-layer coated steel substrate of the invention comprises performing step a) by atomic layer deposition and repeating step a) until having a thickness of the inorganic ceramic layer deposited over the steel substrate from 50 nm to 300 nm. In an embodiment, the process for preparing a bi-layer coated steel substrate of the invention comprises performing step a) by atomic layer deposition and repeating step a) until having a thickness of the inorganic ceramic layer deposited over the steel substrate from 100 nm to 200 nm.

In an embodiment, the process for preparing a bi-layer coated steel substrate, comprising an inner inorganic ceramic layer and an external sol-gel layer, secondly comprises performing step b) by depositing a sol-gel coating composition over the coated steel substrate obtained in step a) to obtain the bi-layer coated steel substrate.

As it is disclosed above, step b) of the process for preparing a bi-layer coated steel substrate of the invention comprises depositing a sol-gel coating composition selected from the group consisting of sol1, sol2 and sol3 over the coated steel substrate obtained in step a) to obtain the bi-layer coated steel substrate.

In an embodiment, step b) of the process for preparing a bi-layer coated steel substrate of the invention comprises depositing sol1, wherein sol1 is a sol-gel coating composition obtainable by a process b1) which comprises:
b1') preparing a first mixture which comprises at least one alkoxide selected from the group consisting of a metal alkoxide, a semimetal alkoxide, an organo-silicon alkoxide and a mixture thereof; and optionally at least one (C₁-C₈)alcohol;
b1") preparing a second mixture with an aqueous solution of at least one acid catalyst having a pH lower than 5; and optionally: at least one organic precursor, at least one (C₁-C₈) alcohol, at least one polymerization initiator or a mixture thereof; and
b1‴) adding the second mixture obtained in step b1") to the resulting mixture of step b1'); and stirring the resulting mixture at a temperature from 15 °C to 45 °C for an appropriate period of time to obtain the sol1; and b1ʺʺ) ageing the resulting mixture by stirring at a temperature from 15 °C to 30 °C for a period of time from 24 h to 72 h;

In an embodiment, step b) of the process for preparing a bi-layer coated steel substrate of the invention comprises depositing sol2, wherein sol2 is a sol-gel coating composition obtainable by a process b2) which comprises:
b2') preparing a mixture which comprises at least one metal alkoxide; and optionally one or more (C₁-C₈) alcohol under an inert and dry atmosphere;
b2") adding a complexing agent to the resulting mixture obtained in step b2'); and stirring the resulting mixture for an appropriate period of time;
b2‴) adding an aqueous solution of at least one acid catalyst having a pH lower than 7 to the resulting mixture obtained in step b2") and stirring the resulting mixture at a temperature from 15 °C to 30 °C for an appropriate period of time to obtain the sol2, and
b2ʺʺ) ageing the resulting mixture by stirring at a temperature from 15 °C to 30 °C for a period of time from 24 h to 72 h.

In an embodiment, step b) of the process for preparing a bi-layer coated steel substrate of the invention comprises depositing sol3, wherein sol3 is a sol-gel coating composition obtainable by a process which comprises mixing the sol1 obtained in step b1‴) or step b1ʺʺ) with the sol2 obtained in step b2‴) or step b2ʺʺ), and ageing the resulting mixture by stirring at a temperature from 15 °C to 30 °C for a period of time from 24 h to 72 h.

In an embodiment, step b) of the process for preparing a bi-layer coated steel substrate of the invention comprises depositing sol1, wherein sol1 is a sol-gel coating composition obtainable by a process b1) as defined above, wherein at least one (C₁-C₈) alcohol is present, and the process comprises preparing a first mixture by mixing at least one metal or semimetal alkoxide or a mixture thereof and at least one (C₁-C₈) alcohol.

In an embodiment, step b) of the process for preparing a bi-layer coated steel substrate of the invention comprises depositing sol1, wherein sol1 is a sol-gel coating composition obtainable by a process b1) as defined above, wherein at least one organo-silicon alkoxide is present, and the process comprises preparing a first mixture by mixing at least one metal or semimetal alkoxide or a mixture thereof and at least one organo-silicon alkoxide.

In an embodiment, step b) of the process for preparing a bi-layer coated steel substrate of the invention comprises depositing sol1, wherein sol1 is a sol-gel coating composition obtainable by a process b1) as defined above, wherein a mixture of at least one (C₁-C₈) alcohol and at least one organo-silicon alkoxide is present and the process comprises preparing a first mixture by mixing at least one metal or semimetal alkoxide or a mixture thereof; at least one (C₁-C₈)alcohol; and at least one organo-silicon alkoxide.

In an embodiment, step b) of the process for preparing a bi-layer coated steel substrate of the invention comprises depositing sol1, wherein sol1 is a sol-gel coating composition obtainable by a process b1) as defined above, wherein at least one organo-silicon alkoxide is present and is selected from the group consisting of:
a compound of formula (I);

   [R⁴]ₛ-Si(OR¹)ₜ(OR²)(OR³) (I)
a compound of formula (II);

   R⁸-(CH₂)ₘ-Si(OR⁵)_{q}R⁶ᵣ (II)
a compound of formula (III)

   (⁹RO)(¹⁰RO)(¹¹RO)Si-X1-Si(OR¹²)(OR¹³)(OR¹⁴) (III)
a mixture of at least a compound of formula (I) wherein R⁴ is (C₁-C₄)alkyl and at least a compound of formula (I) wherein R⁴ is (C₂-C₁₄)alkenyl;
a mixture of at least a compound of formula (I) and at least a compound of formula (II);
a mixture of at least a compound of formula (I) and at least a compound of formula (III); and
a mixture of at least a compound of formula (II) and at least a compound of formula (III).
wherein:
   each one of R¹, R² and R³ are independently selected from the group consisting of a substituted or un-substituted (C₁-C₁₄)alkyl, (C₅-C₆)aryl, (C₂-C₁₄)alkenyl and (C₂-C₁₄)alkynyl group;
   R⁴ is selected from the group consisting of a substituted or un-substituted (C₁-C₄)alkyl and a substituted or un-substituted (C₂-C₁₄)alkenyl;
   R⁵, R⁶, R⁷, R⁹, R¹⁰, R¹¹, R¹², R¹³ and R¹⁴ are independently selected from the group consisting of a substituted or un-substituted (C₁-C₁₄)alkyl, (C₅-C₆)aryl, (C₂-C₁₄)alkenyl, and (C₂-C₁₄)alkyl-CH=CH-;
   R⁸ is selected from the group consisting of H, -SH, substituted or un-substituted (C₁-C₁₂)alkyl, substituted or un-substituted (C₅-C₆)aryl, -(CF₂)_{b}-CF₃, -NR¹⁵R¹⁶, a compound of formula (IV) 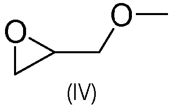
   and a compound of formula (V) 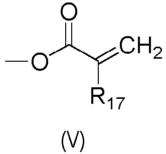
   wherein: R¹⁵ and R¹⁶ are independently selected from the group consisting of H, substituted or un-substituted (C₁-C₁₂)alkyl, -CO, and substituted or un-substituted (C₅-C₆)aryl;
   R¹⁷ is selected from the group consisting of H and substituted or un-substituted (C₁-C₁₂)alkyl;
   X₁ is selected from the group consisting of substituted or unsubstituted -(C₁-C₁₂)alkylene-, -(C₁-C₁₂)alkylene-NH-(C₁-C₁₂)alkylene-, and -(C₁-C₁₂)alkylene-(S)ₙ-(C₁-C₁₂)alkylene-;
   m is an integer from 0 to 20;
   n is an integer from 1 to 4;
   q is an integer from 2 to 3;
   r is an integer from 0 to 1;
   s is an integer from 1 to 2;
   t is an integer from 0 to 1;
   the sum of q + r is 3;
   the sum of s + t is 2; and
   b is an integer from 0 to 12.

In an embodiment, step b) of the process for preparing a bi-layer coated steel substrate of the invention comprises depositing sol1, wherein sol1 is a sol-gel coating composition obtainable by a process b1) as defined above, wherein the organo-silicon alkoxide is present and is a compound of formula (I).

In an embodiment, step b) of the process for preparing a bi-layer coated steel substrate of the invention comprises depositing sol1, wherein sol1 is a sol-gel coating composition obtainable by a process b1) as defined above, wherein the organo-silicon alkoxide is present and is a compound of formula (I) wherein R⁴ is substituted or un-substituted (C₁-C₄)alkyl.

In an embodiment, step b) of the process for preparing a bi-layer coated steel substrate of the invention comprises depositing sol1, wherein sol1 is a sol-gel coating composition obtainable by a process b1) as defined above, wherein the organo-silicon alkoxide is present and is a compound of formula (I) wherein R⁴ is substituted or un-substituted (C₁-C₄)alkyl selected from the group consisting of methyl triethoxysilane (MTES), methyl trimethoxysilane (MTMS), ethyl triethoxysilane, ethyl trimethoxysilane, ), propyl triethoxysilane, propyl trimethoxysilane and a mixture thereof; preferably methyl triethoxysilane (MTES).

In an embodiment, step b) of the process for preparing a bi-layer coated steel substrate of the invention comprises depositing sol1, wherein sol1 is a sol-gel coating composition obtainable by a process b1) as defined above, wherein the organo-silicon alkoxide is present and is a compound of formula (I) wherein R⁴ is substituted or un-substituted (C₂-C₁₄)alkenyl.

In an embodiment, step b) of the process for preparing a bi-layer coated steel substrate of the invention comprises depositing sol1, wherein sol1 is a sol-gel coating composition obtainable by a process b1) as defined above, wherein the organo-silicon alkoxide is present and is a compound of formula (I) wherein R⁴ is substituted or un-substituted (C₂-C₁₄)alkenyl selected from the group consisting of vinyltriethoxysilane (VTES), vinyltrimethoxysilane (VTMS), allyltriethoxysilane, allyltrimethoxysilane, isopropenyltriethoxysilane, isopropenyltrimethoxysilane, and a mixture thereof.

In an embodiment, step b) of the process for preparing a bi-layer coated steel substrate of the invention comprises depositing sol1, wherein sol1 is a sol-gel coating composition obtainable by a process b1) as defined above, wherein the organo-silicon alkoxide is present and is a mixture of a compound of formula (I) wherein R⁴ is substituted or un-substituted (C₁-C₄)alkyl as defined above and a compound of formula (I) wherein R⁴ is substituted or un-substituted (C₂-C₁₄)alkenyl as defined above.

In an embodiment, step b) of the process for preparing a bi-layer coated steel substrate of the invention comprises depositing sol1, wherein sol1 is a sol-gel coating composition obtainable by a process b1) as defined above, wherein the organo-silicon alkoxide is present and is a compound of formula (II).

In an embodiment, step b) of the process for preparing a bi-layer coated steel substrate of the invention comprises depositing sol1, wherein sol1 is a sol-gel coating composition obtainable by a process b1) as defined above, wherein the organo-silicon alkoxide is present and is a compound of formula (II) selected from the group consisting of 3-glycidyloxypropyl)trimethoxysilane (GPTMS), 3-glycidyloxypropyl)triethoxysilane (GPTES), 3-glycidoxypropyldimethoxymethylsilane, methacryloxy propyl trimethoxy silane (MAPTMS), methacryloxy propyl triethoxy silane (MAPTES), phenylaminopropyl triethoxy silane (PAPTMS), mercaptopropyl triethoxy silane (MPTES), 3-isocyanatopropyltriethoxysilane (ICPTES) or 1-[3-(trimethoxysilyl)propyl]ureido (UPS).

In an embodiment, step b) of the process for preparing a bi-layer coated steel substrate of the invention comprises depositing sol1, wherein sol1 is a sol-gel coating composition obtainable by a process b1) as defined above, wherein the organo-silicon alkoxide is present and is a mixture of a compound of formula (I) and a compound of formula (II).

In an embodiment, step b) of the process for preparing a bi-layer coated steel substrate of the invention comprises depositing sol1, wherein sol1 is a sol-gel coating composition obtainable by a process b1) as defined above, wherein the organo-silicon alkoxide is present and is a mixture of a compound of formula (I) wherein R⁴ is substituted or un-substituted (C₁-C₄)alkyl as defined above and a compound of formula (II) as defined above.

In an embodiment, step b) of the process for preparing a bi-layer coated steel substrate of the invention comprises depositing sol1, wherein sol1 is a sol-gel coating composition obtainable by a process b1) as defined above, wherein the organo-silicon alkoxide is present and is a mixture of a compound of formula (I) wherein R⁴ is substituted or un-substituted (C₂-C₁₄)alkenyl as defined above and a compound of formula (II) as defined above.

In an embodiment, step b) of the process for preparing a bi-layer coated steel substrate of the invention comprises depositing sol1, wherein sol1 is a sol-gel coating composition obtainable by a process b1) as defined above, wherein the organo-silicon alkoxide is present and is a compound of formula (III).

In an embodiment, step b) of the process for preparing a bi-layer coated steel substrate of the invention comprises depositing sol1, wherein sol1 is a sol-gel coating composition obtainable by a process b1) as defined above, wherein the organo-silicon alkoxide is present and is a compound of formula (III) selected from the group consisting of bis-silylfunctional precursors, bis-[triethoxysilylpropyl] tetrasulfide silane (BTESTP) and bis-1,2(triethoxysilyl)ethane (BTSE) bis-[3-(trimethoxysilyl)propyl]amine.

In an embodiment, step b) of the process for preparing a bi-layer coated steel substrate of the invention comprises depositing sol1, wherein sol1 is a sol-gel coating composition obtainable by a process b1) as defined above, wherein the organo-silicon alkoxide is present and is a mixture of a compound of formula (I) and a compound of formula (III).

In an embodiment, step b) of the process for preparing a bi-layer coated steel substrate of the invention comprises depositing sol1, wherein sol1 is a sol-gel coating composition obtainable by a process b1) as defined above, wherein the organo-silicon alkoxide is present and is a mixture of a compound of formula (I) wherein R⁴ is substituted or un-substituted (C₁-C₄)alkyl as defined above and a compound of formula (III) as defined above.

In an embodiment, step b) of the process for preparing a bi-layer coated steel substrate of the invention comprises depositing sol1, wherein sol1 is a sol-gel coating composition obtainable by a process b1) as defined above, wherein the organo-silicon alkoxide is present and is a mixture of a compound of formula (I) wherein R⁴ is substituted or un-substituted (C₂-C₁₄)alkenyl as defined above and a compound of formula (III) as defined above.

In an embodiment, step b) of the process for preparing a bi-layer coated steel substrate of the invention comprises depositing sol1, wherein sol1 is a sol-gel coating composition obtainable by a process b1) as defined above, wherein the organo-silicon alkoxide is present and is a mixture of a compound of formula (II) as defined above and a compound of formula (III) as defined below.

In an embodiment, in step b) of the process for preparing a bi-layer coated steel substrate of the invention, at least one organo-silicon alkoxide is present and the molar ratio between the organo-silicon alkoxide and the metal or semimetal alkoxide is from 0.01 to 100, more particularly from 0.1 to 10.

In an embodiment, step b) of the process for preparing a bi-layer coated steel substrate of the invention comprises depositing sol1, wherein sol1 is a sol-gel coating composition obtainable by a process b1) as defined above, wherein the organic precursor is present. In an embodiment, step b) of the process for preparing a bi-layer coated steel substrate of the invention comprises depositing sol1, wherein sol1 is a sol-gel coating composition obtainable by a process b1) as defined above, wherein the organic precursor is present and is selected from the group consisting of:
a compound of formula (VI) 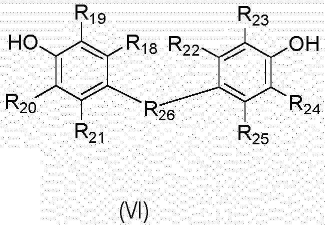 wherein:
R₁₈, R₁₉, R₂₀, R₂₁, R₂₂, R₂₃, R₂₄ and R₂₅ are independently selected from the group consisting of H, substituted or un-substituted (C₁-C₆)alkyl, (C₅-C₆)aryl, (C₂-C₁₄)alkenyl, and (C₂-C₁₄)alkyl-CH=CH- and substituted or un-substituted phenyl;
R₂₆ is selected from the group consisting of CR₂₇R₂₈, SO₂, a compound of formula (VII) 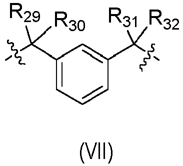
a compound of formula (VIII) 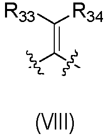
a compound of formula (IX) 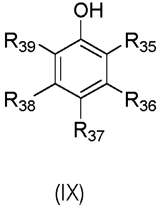
a compound of formula (X) 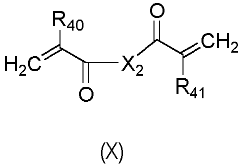
and a mixture thereof
wherein:
   R₂₇ and R₂₈ are independently selected from the group consisting of H, substituted or un-substituted (C₁-C₆)alkyl, (C₅-C₆)aryl, (C₂-C₁₄)alkenyl, (C₂-C₁₄)alkyl-CH=CH-, and substituted or un-substituted phenyl;
   R₂₉, R₃₀, R₃₁ and R₃₂ are independently selected from the group consisting of H, and substituted or un-substituted (C₁-C₆)alkyl, (C₅-C₆)aryl, (C₂-C₁₄)alkenyl, and (C₂-C₁₄)alkyl-CH=CH-;
   R₃₃ and R₃₄ are independently selected from the group consisting of halogen and substituted or un-substituted (C₁-C₆)alkyl, (C₅-C₆)aryl, (C₂-C₁₄)alkenyl, and (C₂-C₁₄)alkyl-CH=CH-;
   R₃₅, R₃₆, R₃₇, R₃₈ and R₃₉ are independently selected from the group consisting of a H, substituted or un-substituted (C₁-C₁₄)alkyl, (C₅-C₆)aryl, (C₂-C₁₄)alkenyl, and (C₂-C₁₄)alkyl-CH=CH, being at least one of R₃₅, R₃₆, R₃₇, R₃₈ and R₃₉ other than H;
   R₄₀ and R₄₁ are independently selected from the group consisting of H and (C₁-C₆)alkyl;
   X₂ is selected from the group consisting of a compound of formula (XI) 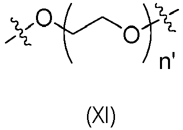
   and a compound of formula (XII); 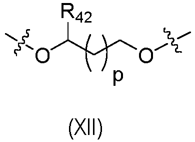
   and a mixture thereof;
   wherein:
      R₄₂ is selected from the group consisting of H and (C₁-C₆)alkyl;
      p is an integer from 1 to 8; and
      n' is an integer from 1 to 6.

In an embodiment, step b) of the process for preparing a bi-layer coated steel substrate of the invention comprises depositing sol1, wherein sol1 is a sol-gel coating composition obtainable by a process b1) as defined above, wherein the organic precursor is present and is a compound of formula (VI). In an embodiment, step b) of the process for preparing a bi-layer coated steel substrate of the invention comprises depositing sol1, wherein sol1 is a sol-gel coating composition obtainable by a process b1) as defined above, wherein the organic precursor is present and is a compound of formula (VI) selected from the group consisting of Bisphenol A (2,2-Bis(4-hydroxyphenyl)propane), Bisphenol AP (1,1-Bis(4-hydroxyphenyl)-1-phenyl-ethane), Bisphenol AF (2,2-Bis(4-hydroxyphenyl)hexafluoropropane), Bisphenol B (2,2-Bis(4-hydroxyphenyl)butane), Bisphenol BP (Bis-(4-hydroxyphenyl)diphenylmethane), Bisphenol C (2,2-Bis(3-methyl-4-hydroxyphenyl)propane), Bisphenol C 2 (Bis(4-hydroxyphenyl)-2,2-dichlorethylene), Bisphenol E (1,1-Bis(4-hydroxyphenyl)ethane), Bisphenol F (Bis(4-hydroxyphenyl)methane), Bisphenol G (2,2-Bis(4-hydroxy-3-isopropyl-phenyl)propane), Bisphenol M (1,3-Bis(2-(4-hydroxyphenyl)-2-propyl)benzene), Bisphenol S (Bis(4-hydroxyphenyl)sulfone), Bisphenol P (1,4-Bis(2-(4-hydroxyphenyl)-2-propyl)benzene), Bisphenol PH (5,5' -(1-Methylethyliden)-bis[1,1'-(bisphenyl)-2-ol]propane), Bisphenol TMC (1,1-Bis(4-hydroyphenyl)-3,3,5-trimethylcyclohexane), Bisphenol Z (1,1-Bis(4-hydroxyphenyl)-cyclohexane), 2,2'-diallyl-bisphenol A and a mixture thereof; particularly Bisphenol A (BPA). In an embodiment, step b) of the process for preparing a bi-layer coated steel substrate of the invention comprises depositing sol1, wherein sol1 is a sol-gel coating composition obtainable by a process b1) as defined above, wherein the organic precursor is present; particularly a compound as defined above, and the molar ratio between the organo-silicon alkoxide and the organic precursor is from 0.1 to 10; particularly from 0.25 to 4.

In an embodiment, step b) of the process for preparing a bi-layer coated steel substrate of the invention comprises depositing sol1, wherein sol1 is a sol-gel coating composition obtainable by a process b1) as defined above, wherein the organic precursor is present and is a compound of formula (IX). In an embodiment, step b) of the process for preparing a bi-layer coated steel substrate of the invention comprises depositing sol1, wherein sol1 is a sol-gel coating composition obtainable by a process b1) as defined above, wherein the organic precursor is present and is a compound of formula (IX) selected from the group consisting of 2-allyl-phenol (AP), 2-allyl-4-methyl-phenol, 2-ethyl-phenol, 2-propyl-phenol, 2-propenyl-phenol and a mixture thereof; particularly 2-allyl-phenol (AP).

In an embodiment, step b) of the process for preparing a bi-layer coated steel substrate of the invention comprises depositing sol1, wherein sol1 is a sol-gel coating composition obtainable by a process b1) as defined above, wherein the organic precursor is present and is a compound of formula (X). In an embodiment, step b) of the process for preparing a bi-layer coated steel substrate of the invention comprises depositing sol1, wherein sol1 is a sol-gel coating composition obtainable by a process b1) as defined above, wherein the organic precursor is present and is a compound of formula (X) selected from the group consisting of ethylene glycol dimethacrylate (EGDMA), di(ethylene glycol) dimethacrylate, tri(ethylene glycol) dimethacrylate, tetra(ethylene glycol) dimethacrylate, ethylene glycol diacrylate, di(ethylene glycol) diacrylate, tri(ethylene glycol) diacrylate, tetra(ethylene glycol) diacrylate, 1,3-butanediol dimethacrylate, 1,3-butanediol diacrylate, 1,6-hexanediol dimethacrylate, 1,6-hexanediol diacrylate and a mixture thereof; particularly ethylene glycol dimethacrylate (EGDMA). In an embodiment, step b) of the process for preparing a bi-layer coated steel substrate of the invention comprises depositing sol1, wherein sol1 is a sol-gel coating composition obtainable by a process b1) as defined above, wherein the organic precursor is present; particularly a compound as defined above, and the molar ratio between the organo-silicon alkoxide and the organic precursor is from 0.1 to 10; particularly from 0.25 to 4.

In an embodiment, step b) of the process for preparing a bi-layer coated steel substrate of the invention comprises depositing sol1, wherein sol1 is a sol-gel coating composition obtainable by a process b1) as defined above, wherein the polymerization initiator is present. In an embodiment, step b) of the process for preparing a bi-layer coated steel substrate of the invention comprises depositing sol1, wherein sol1 is a sol-gel coating composition obtainable by a process b1) as defined above, wherein the polymerization initiator is present and is selected from the group consisting of imidazole compounds, aliphatic amines, phenylenediamines, carboxylic acids and their anhydrides, azo compounds and a mixture thereof. Examples of appropriate imidazole compounds for the present invention include, without limitation, (1-methylimidazole (1-MI), 2-methylimidazole (2-MI), 2-phenylimidazole (2-Phl), 1,2-dimethylimidazole (1,2-DMI), 2-ethyl-4-methylimidazole (2,4-EMI), 1-benzyl-2-methylimidazole (1,2-BMI). Examples of appropriate aliphatic amine include, without limitation, ethylenediamine (EDA), tris(2-aminoethyl)amine (TAEA), triethylenetetramine (TETA), or diethylenetriamine (DETA). Examples of phenylenediamines include without limitation, o-phenylenediamine (o-PDA), m-phenylenediamine (m-PDA), or p-phenylenediamine (p-PDA). Examples of appropriate carboxylic acids include, without limitation, phthalic acid (PA), hexahydrophthalic acid (HHPA), or tetrahydrophthalic acid (THPA). Examples of appropriate anhydrides of carboxylic acids include, without limitation phthalic anhydride (PA), hexahydrophthalic anhydride (HHPA), or tetrahydrophthalic anhydride (THPA). Examples of appropriate azo compounds include, without limitation azobisisobutyronitrile or 2,2'-azobis(2-methylpropionitrile) (AIBN) and 1,1'-azobis(cyclohexanecarbonitrile) (ACHN). In an embodiment, step b) of the process for preparing a bi-layer coated steel substrate of the invention comprises depositing sol1, wherein sol1 is a sol-gel coating composition obtainable by a process b1) as defined above, wherein the polymerization initiator is present and is the imidazole compound 1-methylimidazole (1-MI). In an embodiment, step b) of the process for preparing a bi-layer coated steel substrate of the invention comprises depositing sol1, wherein sol1 is a sol-gel coating composition obtainable by a process b1) as defined above, wherein the polymerization initiator is present in a molar ratio between the organo-silicon alkoxide and the polymerization initiator from 50 to 150; particularly from 50 to 100.

In an embodiment, step b) of the process for preparing a bi-layer coated steel substrate of the invention comprises depositing sol1, wherein sol1 is a sol-gel coating composition obtainable by a process b1) as defined above, wherein at least one organic precursor and at least one polymerization initiator are present.

In an embodiment, step b) of the process for preparing a bi-layer coated steel substrate of the invention comprises depositing sol1, wherein sol1 is a sol-gel coating composition obtainable by a process b1) as defined above, wherein the metal or semimetal alkoxide are independently a compound of formula (XIII):

(OR⁴³)(OR⁴⁴)(OR⁴⁵)(OR⁴⁶)Z (XIII)

wherein: R⁴³, R⁴⁴, R⁴⁵ and R⁴⁶ are independently selected from the group consisting of substituted or un-substituted (C₁-C₁₄)alkyl, (C₅-C₆)aryl, (C₂-C₁₄)alkenyl and (C₂-C₁₄)alkynyl group and Z is selected from the group consisting of the metal and the semimetal atom as defined in the present invention.

In an embodiment, step b) of the process for preparing a bi-layer coated steel substrate of the invention comprises depositing sol1, wherein sol1 is a sol-gel coating composition obtainable by a process b1) as defined above, wherein the metal or semimetal alkoxide is a compound of formula (XIII) and is selected from the group consisting of tetraethylorthosilicate (TEOS), tetramethylorthosilicate (TMOS), aluminium trimethoxide, aluminum ethoxide, aluminium isopropoxide, aluminum tert-butoxide, aluminum-tri-sec-butoxide, zirconium tetrapropoxide (TPOZ), zirconium tetraisopropoxide, titanium tetrapropoxide, titanium tetraisopropoxide, and a mixture thereof.

In an embodiment, step b) of the process for preparing a bi-layer coated steel substrate of the invention comprises depositing sol1, wherein sol1 is a sol-gel coating composition obtainable by a process b1) as defined above, wherein the (C₁-C₈)alcohol is selected from the group consisting of ethanol, butanol, propanol, and a mixture thereof. The term "alcohol" refers to an "alkane" wherein at least one hydrogen atom is substituted by a hydroxyl group and that contains the number of carbon atoms specified in the description or claims. The term "alkane" refers to a saturated, branched or linear hydrocarbon that contains the number of carbon atoms specified in the description or claims. Examples include methanol, ethanol, n-propanol, isopropanol, butanol, iso-butanol, and sec-butanol. In an embodiment, in step b) of the process for preparing a bi-layer coated steel substrate of the invention, the (C₁-C₈) alcohol is n-propanol. In an embodiment, in step b) of the process for preparing a bi-layer coated steel substrate of the invention, the molar ratio between the sum of moles of metal or semimetal alkoxide and organo-silicon alkoxide (particularly the sum of moles of compounds of formula XIII, formula I, formula II and formula III); and the moles of (C₁-C₈) alcohol is from 0.12 to 8; preferably from 0.2 to 5; more preferably from 0.5 to 2.

In an embodiment, step b) of the process for preparing a bi-layer coated steel substrate of the invention comprises depositing sol1, wherein sol1 is a sol-gel coating composition obtainable by a process b1) as defined above, wherein the acid catalyst is an inorganic acid selected from the group consisting of H₂SO₄, HCl, HNO₃, and a mixture thereof; particularly H₂SO₄. The acid catalyst is in form of an aqueous solution having a pH lower than 5; preferably the pH is from 0 to 2. In an embodiment, in step b) of the process for preparing a bi-layer coated steel substrate of the invention, the acid catalyst is H₂SO₄ and is in form of an aqueous acidic solution of H₂SO₄ having a pH lower than 5; preferably the pH is from 0 to 2. In an embodiment, in step b) of the process for preparing a bi-layer coated steel substrate of the invention, the molar ratio between the sum of moles of metal or semimetal alkoxide and organo-silicon alkoxide (particularly the sum of moles of compounds of formula XIII, formula I, formula II and formula III); and the moles of water of the aqueous solution of the acid catalyst is from 0.10 to 2; preferable from 0.20 to 1.5; more preferably from 0.25 to 1.35.

In an embodiment, step b) of the process for preparing a bi-layer coated steel substrate of the invention comprises depositing sol2, wherein sol2 is a sol-gel coating composition obtainable by a process b2) as defined above which is performed under an inert and dry atmosphere. As used herein, the term "inert atmosphere" refers to an atmosphere unsuitable to support combustion, e.g. an atmosphere containing up to 10% oxygen. In an embodiment, step b) of the process for preparing a bi-layer coated steel substrate of the invention comprises depositing sol2, wherein sol2 is a sol-gel coating composition obtainable by a process b2) as defined above which is performed under an inert atmosphere containing up to 5% oxygen. The term "dry atmosphere" refers to an atmosphere with humidity levels below 15%, below 10%; particularly below 5%.

In an embodiment, step b) of the process for preparing a bi-layer coated steel substrate of the invention comprises depositing sol2, wherein sol2 is a sol-gel coating composition obtainable by a process b2) as defined above wherein at least one (C₁-C₈)alcohol purged with an inert gas is present. The expression "purged with an inert gas" refers to insert an inert gas into the reaction tank to reduce the amount of oxygen and/or the humidity levels as defined in the present invention.

In an embodiment, step b) of the process for preparing a bi-layer coated steel substrate of the invention comprises depositing sol2, wherein sol2 is a sol-gel coating composition obtainable by a process b2) as defined above wherein the metal alkoxide is selected from the group consisting of zirconium tetrapropoxide (TPOZ), zirconium tetraisopropoxide, titanium tetrapropoxide, titanium tetraisopropoxide and a mixture thereof.

In an embodiment, step b) of the process for preparing a bi-layer coated steel substrate of the invention comprises depositing sol2, wherein sol2 is a sol-gel coating composition obtainable by a process b2) as defined above wherein the complexing agent is selected from the group consisting of acetyl acetone (AcAc), methacrylic acid (MAc), acetic acid, isobutyric acid, bipyridine, and a mixture thereof; particularly acetyl acetone. In an embodiment, step b) of the process for preparing a bi-layer coated steel substrate of the invention comprises depositing sol2, wherein sol2 is a sol-gel coating composition obtainable by a process b2) as defined above wherein the molar ratio between the metal alkoxide and the complexing agent is from 0.5 to 4; from 0.7 to 3; particularly from 0.7 to 2.

In an embodiment, step b) of the process for preparing a bi-layer coated steel substrate of the invention comprises depositing sol2, wherein sol2 is a sol-gel coating composition obtainable by a process b2) as defined above wherein the (C₁-C₈)alcohol is selected from the group consisting of ethanol, butanol, propanol, and a mixture thereof. The term "alcohol" refers to an "alkane" wherein at least one hydrogen atom is substituted by a hydroxyl group and that contains the number of carbon atoms specified in the description or claims. The term "alkane" refers to a saturated, branched or linear hydrocarbon that contains the number of carbon atoms specified in the description or claims. Examples include methanol, ethanol, n-propanol, isopropanol, butanol, iso-butanol, and sec-butanol. In an embodiment, in step b) of the process for preparing a bi-layer coated steel substrate of the invention, the (C₁-C₈) alcohol is n-propanol. In an embodiment, in step b) of the process for preparing a bi-layer coated steel substrate of the invention, the molar ratio between the metal alkoxide and the (C₁-C₈) alcohol is from 0.1 to 10; preferably from 0.1 to 5; more preferably from 0.1 to 1.

In an embodiment, step b) of the process for preparing a bi-layer coated steel substrate of the invention comprises depositing sol2, wherein sol2 is a sol-gel coating composition obtainable by a process b2) as defined above wherein the acid catalyst is an inorganic acid selected from the group consisting of H₂SO₄, HCl, HNO₃, and a mixture thereof; particularly H₂SO₄. The acid catalyst is in form of an aqueous solution having a pH lower than 5; preferably the pH is from 0 to 2. In an embodiment, in step b) of the process for preparing a bi-layer coated steel substrate of the invention, the acid catalyst is H₂SO₄ and is in form of an aqueous acidic solution of H₂SO₄ having a pH lower than 5; preferably the pH is from 0 to 2. In an embodiment, in step b) of the process for preparing a bi-layer coated steel substrate of the invention, the molar ratio between the sum of moles of metal alkoxide and moles of water of the aqueous acidic solution is from 0.10 to 100; preferable from 0.10 to 10.

In an embodiment, step b) of the process for preparing a bi-layer coated steel substrate of the invention comprises depositing sol3 obtainable by a process which comprises mixing the sol1 obtained in step b1‴) or step b1ʺʺ) with the sol2 obtained in step b2‴) or step b2ʺʺ), and ageing the resulting mixture by stirring at a temperature from 15 °C to 30 °C for a period of time from 24 h to 72 h.

In an embodiment, step b) of the process for preparing a bi-layer coated steel substrate of the invention comprises depositing sol3 obtainable by a process which comprises mixing the sol1 with the sol2 as defined above at a temperature from 15 °C to 30 °C for a period of time from 24 h to 72 h; particularly the ageing is performed at a temperature of 22 °C for 48 h.

All the embodiments disclosed above for the preparation of sol1 and sol2 also apply for the preparation of sol3 which comprises mixing the sol1 with the sol2.

In an embodiment, the process for the process for preparing a bi-layer coated steel substrate, comprising an inner inorganic ceramic layer and an external sol-gel layer further comprises an additional step after step b) which comprises adding an amount of aqueous acidic solution until having a molar ratio between: the sum of moles of metal alkoxide, semimetal alkoxide and organo-silicon alkoxide and the moles of total water is from 0.1 to 8; preferably from 0.2 to 4.

In an embodiment, the process for the process for preparing a bi-layer coated steel substrate, comprising an inner inorganic ceramic layer and an external sol-gel layer further comprises an additional step after step b) which comprises adding an amount of aqueous acidic solution until having a molar ratio between the sum of moles of metal or semimetal alkoxide and organo-silicon alkoxide (particularly the sum of moles of compounds of formula XIII, formula I, formula II, formula III and metal alkoxide corresponding to step b2); and the moles of total water is from 0.1 to 8; preferably from 0.2 to 4.

Step b) can be performed using the known techniques of the state of the art for depositing a sol-gel coating over a substrate. In an embodiment, step b) is performed by depositing the sol-gel layer over steel using a technique selected from the group consisting of spin-coating, web-coating, dip-coating, spray-coating, doctor blade coating, printing such as screen-printing, ink-jet printing, flexographic printing, gravure printing, and micro-gravure printing. In an embodiment, optionally in combination with one or more features of the various embodiments described above or below, the sol-gel coating composition of the invention is deposited over the substrate (step b) by dipping the substrate in the sol-gel coating composition of the second aspect of the invention to obtain a corrosion resistant sol-gel coated substrate.

In an embodiment, optionally in combination with one or more features of the various embodiments described above or below, the sol-gel coating composition of the invention is deposited over the substrate (step b) by dipping the substrate in the sol-gel coating composition of the second aspect of the invention at a deposition rate comprised from 2 cm/min to 40 cm/min.

In an embodiment, step b) of the process for preparing a bi-layer coated steel substrate of the invention is performed by dipping the substrate in the sol-gel coating composition of the second aspect of the invention at a deposition rate comprised from 2 cm/min to 40 cm/min.

As it is mentioned above, the process for preparing a coated substrate comprises a curing step c) after the deposition of the external sol-gel coating composition over the substrate. Step c) of the process of the invention can be performed using the known techniques of the state of the art for curing a coating on a substrate. In an embodiment, step c) is performed by a technique selected from the group consisting of thermal curing; photochemical curing such as ultraviolet curing and infrared curing; microwave induced curing; other options include like latent heat curing when substrate undergoes previous processes generating residual heat. In an embodiment, curing step (step c) is performed by thermal curing at a temperature from 80 °C to 220 °C for an appropriate period of time; from 0.5 h to 48 h; particularly at a temperature from 100 °C to 200 °C for 1 h to 12 h.

In an embodiment, step b) of the process for preparing a coated substrate of the present invention further comprises an additional step of adding one or more additives over sol1, sol2 or sol3. In an embodiment, the additive is selected from the group consisting of a corrosion inhibitor, an ink and a photoinitiator. Examples of appropriate corrosion inhibitors for the present invention include, without limitation, inorganic salts of Cerium, Yttrium, and Manganese; organic compounds such as benzotriazole and benzothiazole derivatives, propargyl alcohol, 8-hydroxyquinoline; ceramic or metallic nanoparticles optionally doped with the corrosion inhibitor. Examples of appropriate inks for the present invention include, without limitation, inorganic and organic inks. Examples of organic inks include, without limitation, erythrosine B, calcien, fluoroscein, trypan blue, and brilliant green. Examples of appropriate photoinitiator for the present invention include, without limitation, cationic UV curing photoinitiators such as diaryliodonium or triarylsulfonium salts; and UV radical photoinitiators such as 2-benzl-2-N,N-dimethylamino-1-(4- morpholinophenyl) butanone, 2,2-dimethoxy-2-phenylacetophenone , 2-hydroxy-2-methylpropiophenone and 2-hydroxy-4'-(2-hydroxyethoxy)-2-methylpropiophenone.

In an embodiment, the process for preparing a coated substrate of the present invention further comprises depositing one or more additional coating (for instance, primers, paints and top-coats, lacquers, other sol-gel coatings) over the external sol-gel layer. Thus, the process of the invention further comprises an additional step d) by depositing one or more coating over the cured coating obtained in step c).

Step d) of the process can be performed using the known techniques of the state of the art for depositing a coating over a substrate. In an embodiment, step d) is performed using a technique selected from the group consisting of spin-coating, web-coating, dip-coating, spray-coating, ink-jet printing, doctor blade coating, printing such as screen-printing, ink-jet printing, flexographic printing, gravure printing, micro-gravure printing, electrophoretic deposition if sol-gel composition contains nanoparticles. In an embodiment, step d) is performed by spraying the cured sol-gel coating obtained in step d) with a coating composition.

In an embodiment, the process for preparing a coated substrate of the present invention further comprises a previous step prior to step a) which comprises conditioning the substrate. The conditioning step of the substrate facilitates the deposition and/or coating steps. Regarding the nature of the substrate, the conditioning step is performed by using the corresponding techniques known in the state of the art e.g. degreasing, cleaning, and/or pickling the substrate. Example of known techniques used for performing the conditioning step of the substrate can be, among others, blasting, polishing, plasma cleaning, UV-Ozone cleaning, ultrasonically cleaning and wet-chemical cleaning. The appropriate preparation/pre-treatment conditions can readily be determined by those skilled in the art according to the type of substrate being used. In a particular embodiment, when the substrate is carbon steel (such as medium-carbon steel), the conditioning steps comprises degreasing and blasting the substrate.

The corrosion resistant bi-layer stack coated steel substrate comprising an inner inorganic ceramic layer and an external sol-gel layer of the present invention may be defined by its preparation process as defined above and therefore, a bi-layer coated steel substrate comprising an inner inorganic ceramic layer and an external sol-gel layer obtainable by the process as defined in the first aspect of the invention is also part of the invention as the second aspect of the invention.

All the embodiments disclosed above for the steps a)-d) of the process of preparing the bi-layer sol-gel coated steel substrate comprising an inner inorganic ceramic layer and an external sol-gel layer of the first aspect of the invention also apply for the bi-layer stack coated steel substrate comprising an inner inorganic ceramic layer and an external sol-gel layer obtainable by the process of the second aspect of the invention.

In an embodiment, sol-gel layer of the bi-layer coated steel obtainable by the process of the invention is one having a Fourier transform infrared spectroscopy (FTIR) spectrum having peaks at about 3370, 2964, 2935, 2875, 2361, 2342, 1890, 1726, 1610, 1511, 1460, 1411, 1383, 1363, 1266, 1082, 835, 791, 670, 566, 451 ± 4 cm⁻¹; and a X-ray Photoelectron Spectroscopy (XPS) spectrum that comprises characteristic peaks at 183.0, 102.8, 532.6, 531.0, 284.8, 286.6 and 288.7 ± 0.15 eV, which is obtainable by the process as defined in the first aspect of the invention, wherein: the semimetal alkoxide is tetraethylorthosilicate (TEOS), the organo-silicon is glycidoxypropyltrimethoxysilane (GPTMS), the organic precursor is bisphenol A (BPA), the metal alkoxide is zirconium (IV) n-propoxide, the complexing agent is acetyl acetone, and the curing step d) is performed at 120 °C for 8 hours.

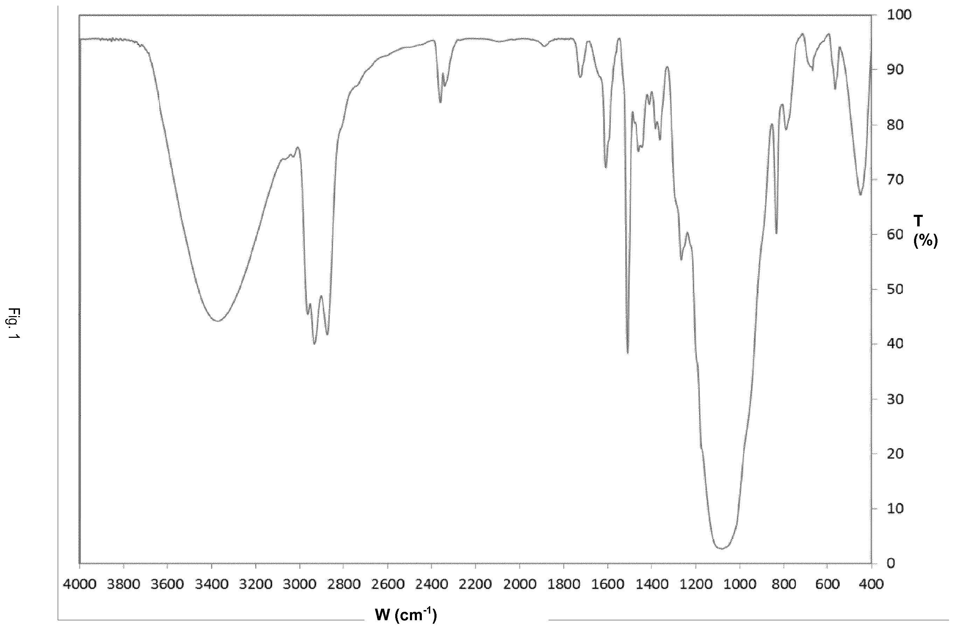

In a particular embodiment, the sol-gel layer of the bi-layer coated steel substrate is one having a Fourier transform infrared spectroscopy (FTIR) spectrum as shown in Figure 1; which is obtainable by the process as defined in the first aspect of the invention, wherein: the semimetal alkoxide is tetraethylorthosilicate (TEOS), the organo-silicon is glycidoxypropyltrimethoxysilane (GPTMS), the organic precursor is bisphenol A (BPA), the metal alkoxide is zirconium (IV) n-propoxide, the complexing agent is acetyl acetone, and the curing step d) is performed at 120 °C for 8 hours.

In an embodiment, the sol-gel layer of the bi-layer coated substrate is one which is further characterized by having a X-ray Photoelectron Spectroscopy (XPS) spectrum that comprises characteristic peaks at 183.0, 102.8, 532.6, 531.0, 284.8, 286.6 and 288.4 ±0.15 eV which is obtainable by the process as defined in the first aspect of the invention, wherein: the semimetal alkoxide is tetraethylorthosilicate (TEOS), the organo-silicon is glycidoxypropyltrimethoxysilane (GPTMS), the organic precursor is bisphenol A (BPA), the metal alkoxide is zirconium (IV) n-propoxide, the complexing agent is acetyl acetone, and the curing step d) is performed at 120 °C for 8 hours.

In an embodiment, the sol-gel layer of the bi-layer coated substrate is one having a Fourier transform infrared spectroscopy (FTIR) spectrum having peaks at about 3370, 2964, 2935, 2875, 2361, 2342, 1890, 1726, 1610, 1511, 1460, 1411, 1383, 1363, 1266, 1082, 835, 791, 670, 566, 451 ± 4 cm⁻¹; and a X-ray Photoelectron Spectroscopy (XPS) spectrum that comprises characteristic peaks at 183.0, 102.8, 532.6, 531.0, 284.8, 286.6 and 288.7 ± 0.15 eV, which is obtainable by the process as defined in the first aspect of the invention wherein: the semimetal alkoxide is tetraethylorthosilicate (TEOS), the organo-silicon is glycidoxypropyltrimethoxysilane (GPTMS), the organic precursor is bisphenol A (BPA), the metal alkoxide is zirconium (IV) n-propoxide, the complexing agent is acetyl acetone, and the curing step d) is performed at 120 °C for 8 hours.

Specifically, the characteristic peaks (expressed in binding energy, eV) of the X-ray photoelectron spectrum as defined above as well as their association with the components of the coating of the invention is shown in Table 1.

**Table 1: List of characteristic peaks acquired using a non-monochromatic X-ray source (Magnesium Ka line, λ = 1253.6 eV and 250 W) operated at 8·10⁻⁸ mbar, with a resolution of 15 eV of pass energy and 0.15 eV/step.**

| Main peaks | Corresponding to | Associated to |
|---|---|---|
| 183.0 eV | Zr 3d_{5/2} | ZrO₂ |
| 102.8 eV | Si 2p | Sub-stoichiometric SiOₓ |
| 532.6 eV | O 1s | C-O and SiOₓ |
| 531.0 eV | O 1s | ZrO₂ |
| 284.8 eV | C 2s | C-C |
| 286.6 eV | C 2s | C-O |
| 288.7 eV | C 2s | C=O |

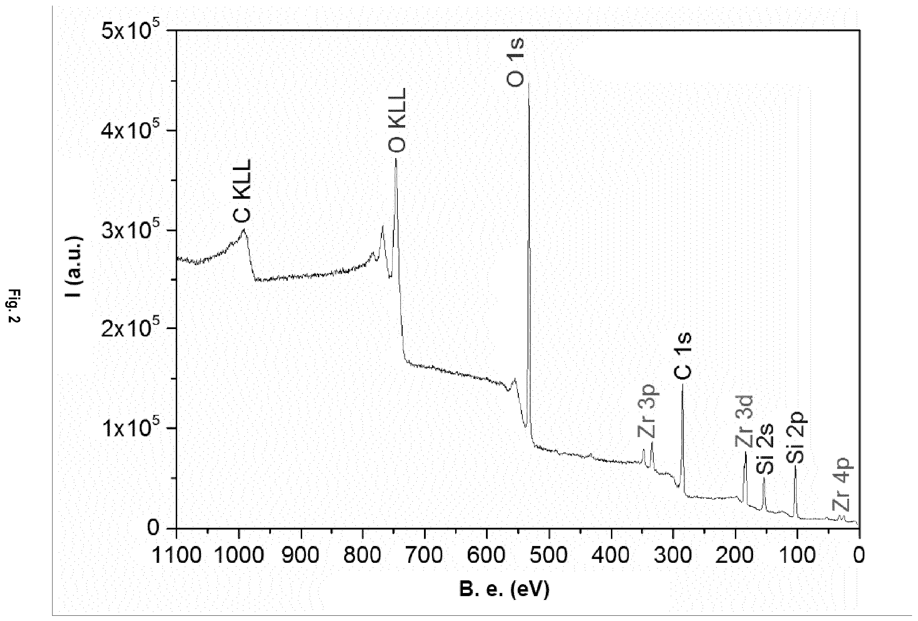

In an embodiment, the sol-gel layer of the bi-layer coated substrate may be further characterized by having a XPS spectrum as shown in Figure 2.

Specifically, the sol-gel layer of the bi-layer coated substrate is one wherein the hydrolysable silicon alkoxide is the tetraethylorthosilicate (TEOS) and silicon-organic alkoxide having at least one non-hydrolysable substituent bonded to the silicon atom being the non-hydrolysable substituent other than a substituted or un-substituted (C1-C4)alkyl is glycidoxypropyltrimethoxysilane (GPTMS); the organic precursor is bisphenol A (BPA); the hydrolysable metal alkoxide is the zirconium (IV) n-propoxide and the complexion agent is acetyl acetone and the curing step d) is performed at 120 °C for 8 hours; is further characterized by having a relative chemical composition expressed in atomic percentage of 3.6% of Zirconium, 18.1% of Silicium, 45.4% of Carbon, and 32.9% of Oxygen.

All the embodiments disclosed above for the steps a)-d) of the first alternative process for the preparation of the bi-layer coated steel substrate comprising an inner inorganic ceramic layer and an external sol-gel layer as defined above.

Throughout the description and claims the word "comprise" and variations of the word, are not intended to exclude other technical features, additives, components, or steps. Furthermore, the word "comprise" encompasses the case of "consisting of'. Additional objects, advantages and features of the invention will become apparent to those skilled in the art upon examination of the description or may be learned by practice of the invention. The following examples are provided by way of illustration, and they are not intended to be limiting of the present invention. Furthermore, the present invention covers all possible combinations of particular and preferred embodiments described herein.

### Examples

### Abbreviation

TEOS: tetraethylorthosilicate
GPTMS: glycidoxypropyltrimethoxysilane
MAPTMS: methacryloxy propyl trimethoxy silane
BPA: bisphenol A
TPOZ: zirconium (IV) n-propoxide
AcAc: acetyl acetone
MAc: methacrylic acid

### General consideration

The Fourier transform infrared (FTIR) spectrum. The spectrum was recorded using a resolution of 4 cm⁻¹, aperture 6 mm, and spectral range of 4000-400 cm⁻¹ (2.5-25 µm). The spectrum expresses the transmittance (%) versus wavelength (cm⁻¹).

Survey spectrum acquired by X-ray Photoelectron Spectroscopy (XPS). The spectrum was captured by spectrometer with a non-monochromatic X-ray source (Magnesium Ka line of 1253.6 eV energy and 250 W), placed perpendicular to the analyzer axis and calibrated using the 3d_{5/2} line of Ag with a full width at half maximum (FWHM) of 1.1 eV. The selected resolution is 30 eV of Pass Energy and 0.5 eV/step. The measurement was made in an ultra-high vacuum (UHV) chamber at a pressure around 8·10⁻⁸ mbar.

Peak positions were calculated from a higher resolution spectrum acquired in the same conditions as survey spectrum but in which selected resolution is 15 eV of Pass Energy and 0.15 eV/step. Peak positions were calculated by fitting experimental results by means of software CasaXPS V2.3.15dev87.

The relative chemical composition was determined by calculations using software CasaXPS V2.3.15dev87, based on the relative areas and sensitivity factors of the Zr 3d, Si 2p, C 1s and O 1s higher resolution spectrum.

### 1. Corrosion-resistant bi-layer stack coated steel substrate of the present invention

### 1.1. Composition of the bi-layer coated steel substrate

### 1.1.1. Substrate

The substrate used for the preparation of the bi-layer coated steel of the present invention is the medium-carbon steel S355J2+N whose composition/properties is defined according to EN 10025 European standard.

The amount of the components of the S355J2+N medium-carbon steel expressed in weight percent are detailed in Table 2:

**Table 2: Chemical composition of S355J2+N medium-carbon steel.**

| **C %** | **Si %** | **Mn %** | **P%** | **S%** | **N%** | **Cu%** |
|---|---|---|---|---|---|---|
| 0.2-0.24 | 0.55 | 1.6 | 0.025-0.035 | 0.025-0.035 | 0-0.012 | 0.55 |

### 1.1.2. Inorganic ceramic coating composition

The inorganic ceramic coating composition for the preparation of the inorganic ceramic layer over the substrate is formed by Al₂O₃ (i.e. inorganic ceramic coating composition Ex. 1).

### 1.1.3. Sol-gel coating composition

### Composition

The amount of the components (expressed in moles) for the preparation of the sol-gel layer over the substrate are disclosed in Table 3.

**Table 3: Components and moles for preparing sol-gel formulation coating.**

| **Ingredients** | | **Sol-gel coating composition** | | | | | |
|---|---|---|---|---|---|---|---|
| **Sol** | **Description** | **Example 1** | | **Example 2** | | **Example 3** | |
| | | **Name** | **Mole** | **Name** | **Mole** | **Name** | **Mole** |
| Sol 1 | Metal or semimetal alkoxide | TEOS (XIII) | 1 | TEOS (XIII) | 1 | | - |
| | Organo-silicon alkoxide | GPTMS (II) | 1 | GPTMS (II) | 2 | MAPTMS (II) | 1 |
| | Aqueous solution of an acid catalyst | H₂SO₄ 0.1M | 4 | H₂SO₄ 0.1M | 6 | HNO₃ 0.01M | 0.75 |
| | Organic precursor | Bisphenol A (BPA)-(VI) | 0.5 | Bisphenol A (BPA)-(VI) | 1 | - | - |
| | Polymerization initiator | 1-methyl imidazole (1-MI) | - | 1-methyl imidazole (1-MI) | - | - | - |
| | (C₁-C₈)alcohol | n-propanol | 2 | n-propanol | 2 | - | - |
| Sol 2 | metal alkoxide | TPOZ | 0.40 | TPOZ | 0.60 | TPOZ | 0.25 |
| | Complexing agent | AcAc | 0.57 | AcAc | 0.85 | MAc | 0.25 |
| | Aqueous solution of an acid catalyst | H₂SO₄ 0.1M | 1.13 | H₂SO₄ 0.1M | 1.71 | HNO₃ 0.01M | 2 |
| | (C₁-C₈)alcohol | n-propanol | 6.51 | n-propanol | 5.66 | n-propanol | 0.12 |

### Preparation process of the sol-gel coating composition

### Examples 1-2

### -Preparation of sol 1

The amounts of TEOS, GPTMS and the organic precursor BPA respectively disclosed in the Table 3 were mixed in the above mentioned amount of n-propanol in which the aqueous solution of H₂SO₄ 0.1M was added.

The resulting solution thus obtained was stirred during 3 h at 40 °C to obtain a transparent sol 1.

### -Preparation of sol 2

Separately and simultaneously, the above disclosed amount of n-propanol was placed in a reactor in which air was replaced by an inert gas (for instance, Ar or N₂ media). Then, the above disclosed amount of solution of TPOZ of 70% weight in n-propanol and AcAc were introduced in the reactor and stirred during 1 hour. After that time, the aqueous solution of H₂SO₄ 0.1M was added to the previous solution and kept stirring for 24 hours to obtain a transparent sol 2.

### -Preparation of sol3 (Mixture of sol 1 and sol 2)

Sol 1 and sol 2 previously prepared were admixed to form the transparent sol-gel coating composition.

### Example 3

### -Preparation of sol 1

The amounts of MAPTMS and aqueous solution HNO₃ 0.01M disclosed in the Table 3 were mixed. The resulting solution thus obtained was stirred during 45 min at room temperature to obtain a transparent sol 1.

### -Preparation of sol 2

Separately and simultaneously, the above disclosed amount of solution of TPOZ of 70% weight in n-propanol and MAc were introduced in the reactor and stirred during 45 min.

### -Preparation of sol3 (Mixture of sol 1 and sol 2)

Sol 1 and sol 2 previously prepared were then admixed and the final amount of aqueous solution HNO₃ 0.01M disclosed in the Table 3 was added to form the transparent sol-gel coating composition.

### 1.1.4 Composition of the bi-layer coated steel substrate of the present invention

### 1.1.4.1 Composition of the bi-layer formed by an inner inorganic ceramic layer and an external sol-gel layer

The composition of the bi-layer coated steel substrate of the present invention is disclosed in Table 4.

**Table 4: Bi-layer coated steel formed by inner inorganic ceramic layer by ALD and sol-gel coating.**

| **Bi-layer coated steel** | **Substrate** | **Inner inorganic ceramic layer** | | **External sol-gel layer** | | |
|---|---|---|---|---|---|---|
| | | **Composition** | **Thickness (nm)** | **Composition** | **Withdrawal rate (cm/min)** | **Thickness (µm)** |
| **B1** | S355J2+N medium-carbon steel | Inorganic ceramic coating comp. Ex. 1 deposited by ALD | 100 | Sol-gel coating comp. Ex. 1 | 32 | 4-5 |
| **B2** | S355J2+N medium-carbon steel | Inorganic ceramic coating comp. Ex.1 deposited by ALD | 200 | Sol-gel coating comp. Ex. 1 | 32 | 4-5 |
| **B3** | S355J2+N medium-carbon steel | Inorganic ceramic coating comp. Ex.1 deposited by ALD | 200 | Sol-gel coating comp. Ex. 2 | 32 | 6-7 |
| **B4** | S355J2+N medium-carbon steel | Inorganic ceramic coating comp. Ex. 1 deposited by ALD | 200 | Sol-gel coating comp. Ex. 3 | 12 | 7-8 |
| **B6** | S355J2+N medium-carbon steel | Inorganic ceramic coating comp. Ex. 3 deposited by PVD | 2500 | Sol-gel coating comp. Ex. 3 | 12 | 7-8 |

### INORGANIC CERAMIC LAYER GROWN BY ATOMIC LAYER DEPOSITION (ALD)

### Preparation process

The process for the preparation of the bi-layer stack corrosion-resistant coated steel substrate of the present invention is as defined below:

### A. Pre-treatment

The metal surface of the medium-carbon steel S355J2+N to be coated was firstly submitted at a degreasing treatment followed by a second treatment of mechanical etching and activation. The pre-treatment process comprises the following steps:
**Step 1:** Introducing the substrate in acetone under ultrasonication conditions during 15 min for degreasing;
**Step 2:** Shot blasting the degreased substrate obtained in step 1 using white corundum particles being equal to or higher than 50 % of them diameter sized from 50 to 56 µm, at 3 bar and at a distance from 7 to 30 cm;
**Step 3:** Introducing the substrate obtained in step 2 in acetone under ultrasonication conditions during 15 min for cleaning and removal of remaining corundum particles.

### B. Deposition of the inner inorganic ceramic coating composition by ALD onto the pre-treated steel substrate

The degreased and blasted substrate obtained in the previous steps was introduced in the corresponding atomic layer deposition (ALD) chamber in which the inner inorganic ceramic coating composition as defined in section 1.1.2. was deposited until reaching 100 nm or 200 nm of layer thickness. The process for the deposition of the inner layer onto the degreased and blasted substrate is as follows:
Al₂O₃ synthesized by ALD was conducted in the commercial reactor Beneq TFS200 by exposing the steel substrate to alternating vapours of trimethylaluminum (TMA) and demineralized water in an evacuated reaction chamber. The base pressure of the chamber was 0.5 mbar and the precursor pulsing sequence was 250 ms pulse of TMA, 1.5 s inert gas (N₂) purge to remove excess TMA form the chamber, 2.5 ms pulse of H₂O vapour, and 2.5s inert gas purge to remove reaction by-products and excess water. This deposition cycle was repeated until the target thicknesses of the coatings were obtained. Particularly, 832 cycles are required for an inner coating of 100 nm (inner inorganic ceramic layer Ex.1); and 1724 cycles for an inner coating of 200 nm (inner inorganic ceramic layer Ex. 2).

### C. Deposition of the external sol-gel coating composition

The substrate coated with the inner inorganic ceramic layer obtained in the previous steps was introduced in the corresponding external sol-gel coating composition obtained in section 1.1.3. and then, it was withdrawn at a rate from 2 cm/min to 40 cm/min and cured at a temperature from 120 °C to 180 °C for a period of time from 1 h to 8 h to obtain the external coating of the bi-layer stack corrosion-resistant coated steel substrate of the present invention (Bi-layer coated steel substrate of Example B1, B2, B3 and B4).

### INORGANIC CERAMIC LAYER GROWN BY PHYSICAL VAPOR DEPOSITION (PVD)

### Preparation Process

The process for the preparation of the bi-layer stack corrosion-resistant coated steel substrate of the present invention is as defined below.

### A. Pre-treatment

The metal surface of the medium-carbon steel S355J2+N to be coated was firstly submitted at a degreasing treatment followed by a second treatment of mechanical etching and activation. The pre-treatment process comprises the following steps:
**Step 1:** Introducing the substrate in acetone under ultrasonication conditions during 15 min for degreasing;
**Step 2:** Shot blasting the degreased substrate obtained in step 1 using white corundum particles being equal to or higher than 50 % of them diameter sized from 50 to 56 µm, at 3 bar and at a distance from 7 to 30 cm;
**Step 3:** Introducing the substrate obtained in step 2 in acetone under ultrasonication conditions during 15 min for cleaning and removal of remaining corundum particles.

### B. Deposition of the inner inorganic ceramic coating composition by PVD onto the pre-treated steel substrate

The degreased and blasted substrate obtained in step A was introduced in the corresponding physical vapor deposition (PVD) chamber in which the inner inorganic ceramic coating composition Ex-3 obtained in section 1.1.2. was deposited until reaching 2.5 µm of layer thickness, which comprises the following steps:
Al₂O₃ coating synthesis by PVD, specifically by DC-pulse reactive magnetron sputtering technique, was conducted in the commercial equipment CC800/8 from CemeCon. First step consisted of introducing the steel substrate and aluminium targets in a vacuum chamber at 8 x 10⁻⁶ mbar as base pressure and temperature between 300 - 500 °C achieved by resistive heating of the coating chamber at 4 kW during 1 h. Then, an Ar and O₂ gas mixture was introduced in the vacuum chamber using a speed flow closed loop controller. The Ar working process was 7.5 x 10⁻³ mbar and negative polarization on Al targets was applied at 2 kW and medium frequency (MF). Reaction between sputtered Al atoms and O₂ took place and Al₂O₃ deposited on steel substrate (0 V bias) during 180 min to form the inner inorganic layer Esx.3 deposited by PVD on the substrate.

### C. Deposition of the external sol-gel coating composition

The substrate coated with the inner inorganic ceramic layer obtained by PVD in the previous step B was introduced in the corresponding external sol-gel coating composition obtained in section 1.1.3 and then, it was withdrawn at a rate from 2 cm/min to 40 cm/min and cured at a temperature from 120 °C to 180 °C for a period of time from 1 h to 8 h to obtain the external coating of the bi-layer stack corrosion-resistant coated steel substrate of the present invention (Bi-layer coated steel substrate of Example B6).

### 1.1.4.2 Composition of the bi-layer formed by an inner sol-gel layer and an external inorganic ceramic layer by ALD

This example is not according to the invention and is present for illustration purposes only.

The composition of the bi-layer coated steel substrate of the present invention is disclosed in Table 5.

**Table 5: Bi-layer coated steel formed by inner sol-gel coating and inorganic ceramic layer by ALD.**

| **Bi-layer coated steel** | **Substrate** | **Inner sol-gel layer** | | | **External inorganic ceramic layer** | |
|---|---|---|---|---|---|---|
| | | **Composition** | **Withdrawal rate (cm/min)** | **Thickness (nm)** | **Composition** | **Thickness (µm)** |
| **B5** | S355J2+N | Sol-gel coating comp. Ex. 1 | 32 | 4-5 | Inorganic ceramic coating comp. Ex. 1 deposited by ALD | 100 nm |
| | medium-carbon steel | | | | | |

### Preparation process

The process for the preparation of the bi-layer stack corrosion-resistant coated steel substrate of the present invention is as defined below:

### A. Pre-treatment

The metal surface of the medium-carbon steel S355J2+N to be coated was firstly submitted at a degreasing treatment followed by a second treatment of mechanical etching and activation. The pre-treatment process comprises the following steps:
**Step 1:** Introducing the substrate in acetone under ultrasonication conditions during 15 min for degreasing;
**Step 2:** Shot blasting the degreased substrate obtained in step 1 using white corundum particles being equal to or higher than 50 % of them diameter sized from 50 to 56 µm, at 3 bar and at a distance from 7 to 30 cm;
**Step 3:** Introducing the substrate obtained in step 2 in acetone under ultrasonication conditions during 15 min for cleaning and removal of remaining corundum particles.

### B. Deposition of the inner sol-gel coating composition

The degreased and blasted substrate obtained in the previous steps was introduced in the corresponding sol-gel coating composition obtained in section 1.1.3. and then, it was withdrawn at a rate from 2 cm/min to 40 cm/min and cured at a temperature from 120 °C to 180 °C for a period of time from 1 h to 8 h to obtain the steel coated with the sol-gel mono-layer

### C. Deposition of the external inorganic ceramic layer by ALD

The substrate coated with the inner sol-gel coating mono-layer obtained in the previous steps was introduced in the corresponding atomic layer deposition (ALD) chamber in which the inorganic ceramic coating composition as defined in section 1.1.2. was deposited until reaching 100 nm of layer thickness. The process for the deposition of the external layer onto the substrate coated with a sol-gel mono-layer is as follows:
Al₂O₃ synthesized by ALD coated with the sol-gel mono-layer was conducted in the commercial reactor Beneq TFS200 by exposing the coated steel substrate to alternating vapours of trimethylaluminum (TMA) and demineralized water in an evacuated reaction chamber. The base pressure of the chamber was 0.5 mbar and the precursor pulsing sequence was 250 ms pulse of TMA, 1.5 s inert gas (N₂) purge to remove excess TMA form the chamber, 2.5 ms pulse of H₂O vapour, and 2.5s inert gas purge to remove reaction by-products and excess water. This deposition cycle was repeated until the target thicknesses of the coatings were obtained. Particularly, 832 cycles are required for a coating of 100 nm (inorganic ceramic layer Ex.1); and 1724 cycles for a coating of 200 nm (inorganic ceramic layer Ex. 2).

### 2. Comparative mono-layer coated steel substrate

### 2.1. Comparative steel substrate coated by a mono-layer of an inorganic ceramic coating composition by ALD (comparative mono-layer steel substrate M1 and M2)

The comparatives M1 and M2 mono-layer steel substrate are formed by a layer of the inorganic Al₂O₃ coating composition 1 disclosed in section 1.1.2. having a 100 nm (comparative M1) or 200 nm (comparative M2) of thickness over the S355J2+N steel substrate. The process for its preparation comprises performing firstly, the pre-treatment step (A) followed by the deposition step (B) disclosed in previous section.

### 2.2. Comparative steel substrate coated by a mono-layer of a sol-gel coating composition

### Comparative mono-layer steel substrate M3

The comparative mono-layer steel substrate M3 is formed by the sol-gel coating composition of Example 1 disclosed in section 1.1.3. deposited by dip coating at 32 cm/min withdrawal rate over the S355J2+N steel substrate. The process for its preparation comprises performing the pre-treatment step (A) followed by the deposition step (C) disclosed in previous section.

### Comparative mono-layer steel substrate M4

The comparative mono-layer steel substrate M4 is formed by the sol-gel coating composition of Example 2 disclosed in section 1.1.3. deposited by dip coating at 32 cm/min withdrawal rate over the S355J2+N steel substrate. The process for its preparation comprises performing the pre-treatment step (A) followed by the deposition step (C) disclosed in previous section.

### Comparative mono-layer steel substrate M5 and M6

The comparative mono-layer steel substrate M5 is formed by the sol-gel coating composition of Example 3 disclosed in section 1.1.3. deposited by dip coating at 5 cm/min (comparative M5) and at 12 cm/min (comparative M6) withdrawal rate over the S355J2+N steel substrate. The process for its preparation comprises performing the pre-treatment step (A) followed by the deposition step (C) disclosed in previous section.

### 3. Corrosion Test

### 3.1. Tested Samples

Comparative samples: Bare substrate: steel S355J2+N medium-carbon steel
Comparative mono-layer (inorganic oxide) steel substrate M1
Comparative mono-layer (inorganic oxide) steel substrate M2
Comparative mono-layer (sol-gel) steel substrate M3
Comparative mono-layer (sol-gel) steel substrate M4
Comparative mono-layer (sol-gel) steel substrate M5
Comparative mono-layer (sol-gel) steel substrate M6
Bi-layer coated steel substrate B5 (sol-gel Ex 1 + ALD 100 nm)

Samples of the invention:
Bi-layer coated steel substrate B1 (ALD 100 nm + sol-gel Ex 1)
Bi-layer coated steel substrate B2 (ALD 200 nm + sol-gel Ex 1)
Bi-layer coated steel substrate B3 (ALD 200 nm + sol-gel Ex 2)
Bi-layer coated steel substrate B4 (ALD 200 nm + sol-gel Ex 3)
Bi-layer coated steel substrate B6 (PVD 2500 nm + sol-gel Ex 3)

### 3.2. Methods

The corrosion test of the samples as defined above was performed following one of the methods disclosed below.

### - Test of Neutral Salt Spray Fog Test (NSST) disclosed in the ASTM B-117-16.

All the samples mentioned above were tested in a C&W SF/1000/CCT corrosion chamber that met the conditions of the ASTM B 117 standard. According to Section 8.1 and 10.1 of ASTM B117 standard, the salt solution consists of 5±1 parts of NaCl in 95 parts by mass of deionised water and the temperature in the exposure zone shall be maintained at 35±2 °C. The tested samples were supported at 15 °. The borders of all the samples were masked by brushing an epoxy paint (Hempadur-mastic-45880 form Hempel) on the edges.

### - Electrochemical Impedance Spectroscopy (EIS)

Electrochemical impedance spectroscopy (EIS) was employed to monitor corrosion performance of all the samples mentioned above by immersing them in 0.005 M NaCl solution during 3 days of immersion. The electrochemical cell was composed by three electrodes consisting of working electrode (9.62 cm² exposed area respectively of bare and coated S355J2+N), Ag/AgCl/KCl sat reference electrode and Pt wire counter electrode. EIS measurements were carried out at the open circuit potential (OCP), using a Methrom Autolab PG-STAT 128N potentiostat equipped with a frequency response analyzer module. Impedance data were obtained as a function of frequency (10⁵ Hz to 10⁻² Hz), using a sine wave of 15 mV amplitude root mean square (RMS).

### 3.3. Results

### 3.3.1. Results of the Test of Neutral Salt Spray Fog Test (NSST) disclosed in the ASTM B-117-16

The results of the corrosion test obtained after exposure in NSST are shown in the Table 6.

**Table 6: Corrosion assessment after NSST exposure.**

| **Tested Samples** | **Naked eye assessment** |
|---|---|
| Bi-layer coated steel substrate B1 | Slightly emergence of signs of corrosion after 48 h of exposure |
| | Little but abundant pitting points after 72 h of exposure |
| | Drained products after 168 - 240 h of exposure |
| | Generalised corrosion after 336 h of exposure |
| Bi-layer coated steel substrate B2 | No corrosion evidence after 72 h of exposure |
| | Emergence of few isolated pitting points after 100 h of exposure |
| | Emergence of generalized small pitting points after 168 h that evolve very slow up to 336 h of exposure |
| | Drained products (but no generalised corrosion) after 500 h of exposure |
| | No generalized corrosion at the end of test |
| Bi-layer coated steel substrate B3 | No corrosion evidence after 72 - 100 h of exposure |
| | Less than 5 little pitting points all over surface after 100 h of exposure |
| | Emergence of few isolated red pitting points after 168 h of exposure that evolve very slow up to 336 h of exposure |
| | Slightly staring of drained products after 336 h of exposure |
| | Drained products (but no generalised corrosion) after 500 h of exposure |
| | No generalized corrosion at the end of test |
| Bi-layer coated steel substrate B4 | No corrosion evidence after 100 - 168 h of exposure |
| | Less than 5 little pitting points all over surface after 168 h of exposure |
| | Emergence of few isolated pitting points after 200 h of exposure |
| | Drained products starting from pitting points after 336 h of exposure |
| | Generalised corrosion over more than half part of the surface after 550 h of exposure |
| Bi-layer coated steel substrate B6 | No corrosion evidence after > 200 h of exposure |
| Comparative bare substrate | Generalised corrosion after 24 h of exposure |
| Comparative mono-layer (inorganic oxide) steel substrate M1 | Red corrosion and drained products all over surface after 24 h of exposure |
| | Generalised corrosion after 48 h of exposure |
| Comparative mono-layer (inorganic oxide) steel substrate M2 | Red corrosion and drained products on surface after 24 h of exposure |
| | Generalised corrosion after 48 h of exposure |
| Comparative mono-layer (sol-gel) steel substrate M3 | Generalised corrosion after 24 h of exposure |
| Comparative mono-layer (sol-gel) steel substrate M4 | Emergence of isolated pitting points after 24 h of exposure |
| | Red corrosion and drained products all over surface after 72 h of exposure |
| | Generalised corrosion after 168 h of exposure |
| Comparative mono-layer (sol-gel) steel substrate M5 | Generalised corrosion after 24 h of exposure |
| Comparative mono-layer (sol-gel) steel substrate M6 | Emergence of isolated pitting points after 24 h of exposure |
| | Generalised corrosion after 100 h of exposure |

### 3.3.2. Results of the EIS measurement

As mentioned above, the EIS measurements are shown in Figure 3. The impedance values of the bi-layer coated steel substrate (B1) of the present invention at low frequencies (10⁻² - 10⁻¹ Hz) are one order of magnitude higher than the impedance values of any of the comparative mono-layers coated steel substrate falling outside the scope of protection (M1 and M3) (~10⁷ Ωcm² vs ~10⁶ Ωcm²) at the beginning of the test and two orders after 24 h of immersion (~10⁶ Ωcm² vs ~10⁴ Ωcm²). These impedance values are related to the resistance of the whole system to electrochemical processes such as corrosion of the metal. Regarding the corrosion protection mechanisms of the comparative mono-layers M1 and M3, a different behaviour is revealed, by the impedance values observed in the region of medium frequencies (10⁰ - 10³ Hz) of the spectra. The higher impedance values of the comparative mono-layer M3 are related to the barrier effect. The spectra of the bi-layers B1 of the present invention, which is the stacking of the corresponding M1 and M3 mono-layers reveal an outstanding synergistic combination of the individual effects of M1 and M3.

### 3.4. Conclusion

The above mentioned results clearly show that in comparison with the bare substrate and the comparative steel coated with either a mono-layer of an inorganic composition or a mono-layer of a sol-gel composition, the bi-layer coated steel substrate of the present invention present a much more efficient corrosion protection, by delaying the formation of defects for a prolonged period of time.

Therefore, the use of bi-layer formed by inorganic ceramic layer (particularly obtained by ALD and PVD) and sol-gel coating system over a steel substrate leads to a coated steel that has lower corrosion rate and it is therefore showing high resistance to corrosion and durability properties.

### Citation List

1. ASTM B 117 standard.
2. EN10025 standard.

## Claims

1. A process for preparing a bi-layer coated steel substrate comprising:
an inner inorganic ceramic layer and an external sol-gel layer, wherein the process comprises:
a) firstly, depositing an inorganic ceramic coating composition over a steel substrate to obtain a steel substrate coated by an inorganic ceramic mono-layer;
b) secondly, depositing a sol-gel coating composition selected from the group consisting of sol1, sol2 and sol3 over the coated steel substrate obtained in step a) to obtain the bi-layer coated steel substrate;
and c) thirdly, curing the coating obtained in step b);
and optionally; the process further comprises an additional step d) which comprises depositing one or more additional coatings over the bi-layer coated steel substrate obtained in step c);
wherein:
the sol1 is a sol-gel coating composition obtainable by a process b1) which comprises:
b1') preparing a first mixture which comprises at least one alkoxide selected from the group consisting of a metal alkoxide, a semimetal alkoxide, an organo-silicon alkoxide and a mixture thereof; and optionally at least one (C₁-C₈)alcohol;
b1") preparing a second mixture with an aqueous solution of at least one acid catalyst having a pH lower than 5; and optionally: at least one organic precursor, at least one (C₁-C₈) alcohol, at least one polymerization initiator or a mixture thereof; and
b1‴) adding the second mixture obtained in step b1") to the resulting mixture of step b1'); and stirring the resulting mixture at a temperature from 15 °C to 45 °C for an appropriate period of time to obtain the sol1; and
b1ʺʺ) ageing the resulting mixture by stirring at a temperature from 15 °C to 30 °C for a period of time from 24 h to 72 h;
the sol2 is a sol-gel coating composition obtainable by a process b2) which comprises:
b2') preparing a mixture which comprises at least one metal alkoxide; and optionally one or more (C₁-C₈) alcohol under an inert and dry atmosphere;
b2") adding a complexing agent to the resulting mixture obtained in step b2'); and stirring the resulting mixture for an appropriate period of time;
b2‴) adding an aqueous solution of at least one acid catalyst having a pH lower than 7 to the resulting mixture obtained in step b2") and stirring the resulting mixture at a temperature from 15 °C to 30 °C for an appropriate period of time to obtain the sol2, and
b2ʺʺ) ageing the resulting mixture by stirring at a temperature from 15 °C to 30 °C for a period of time from 24 h to 72 h;
and
the sol3 is a sol-gel coating composition obtainable by a process which comprises mixing the sol1 obtained in step b1‴) or step b1ʺʺ) with the sol2 obtained in step b2‴) or step b2ʺʺ), and ageing the resulting mixture by stirring at a temperature from 15 °C to 30 °C for a period of time from 24 h to 72 h;
**characterised in that** step a) is performed using a technique selected from the group consisting of atomic layer deposition, chemical vapour deposition and physical vapour deposition.

2. The process for preparing the bi-layer coated steel substrate according to claim 1, wherein:
in step b1') the at least one (C₁-C₈)alcohol and the at least one organo-silicon alkoxide are present and the process comprises preparing a first mixture by mixing at least one metal or semimetal alkoxide or a mixture thereof; at least one (C₁-C₈)alcohol; and at least one organo-silicon alkoxide; and
in step b1") the at least one organic precursor, the one or more (C₁-C₈) alcohol and the at least one polymerization initiator are present and the process comprises preparing a second mixture by mixing an aqueous solution of at least one acid catalyst having a pH lower than 5, at least one organic precursor, at least one (C₁-C₈) alcohol, and at least one polymerization initiator; and stirring the resulting mixture for an appropriate period of time to obtain the sol1.

3. The process for preparing the bi-layer coated steel substrate according to any of the claims 1 or 2, wherein
the organo-silicon alkoxide is selected from the group consisting of:
a compound of formula (I);
[R⁴]ₛ-Si(OR¹)ₜ(OR²)(OR³) (I)
a compound of formula (II);
[R⁸-(CH₂)ₘ]-Si(OR⁵)_{q}R⁶ᵣ (II)
a compound of formula (III)
(⁹RO)(¹⁰RO)(¹¹RO)Si-X₁-Si(OR¹²)(OR¹³)(OR¹⁴) (III)
a mixture of at least a compound of formula (I) wherein R⁴ is (C₁-C₄)alkyl and at least a compound of formula (I) wherein R⁴ is (C₂-C₁₄)alkenyl;
a mixture of at least a compound of formula (I) and at least a compound of formula (II);
a mixture of at least a compound of formula (I) and at least a compound of formula (III);
a mixture of at least a compound of formula (II) and at least a compound of formula (III);
wherein:
each one of R¹, R² and R³ are independently selected from the group consisting of a substituted or un-substituted (C₁-C₁₄)alkyl, (C₅-C₆)aryl, (C₂-C₁₄)alkenyl and (C₂-C₁₄)alkynyl group;
R⁴ is selected from the group consisting of a substituted or un-substituted (C₁-C₄)alkyl and a substituted or un-substituted (C₂-C₁₄)alkenyl;
R⁵, R⁶, R⁷, R⁹, R¹⁰, R¹¹, R¹², R¹³ and R¹⁴ are independently selected from the group consisting of a substituted or un-substituted (C₁-C₁₄)alkyl, (C₅-C₆)aryl, (C₂-C₁₄)alkenyl, and (C₂-C₁₄)alkyl-CH=CH-;
R⁸ is selected from the group consisting of H, -SH, substituted or un-substituted (C₁-C₁₂)alkyl, substituted or
un-substituted (C₅-C₆)aryl, -(CF₂)_{b}-CF₃, -NR¹⁵R¹⁶, a compound of formula (IV) 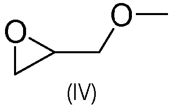
and a compound of formula (V) 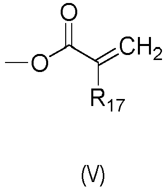
R¹⁵ and R¹⁶ are independently selected from the group consisting of H, substituted or un-substituted (C₁-C₁₂)alkyl, -CO, and substituted or un-substituted (C₅-C₆)aryl;
R¹⁷ is selected from the group consisting of H and substituted or un-substituted (C₁-C₁₂)alkyl;
X₁ is selected from the group consisting of substituted or unsubstituted -(C₁-C₁₂)alkylene-, -(C₁-C₁₂)alkylene-NH-(C₁-C₁₂)alkylene-, and -(C₁-C₁₂)alkylene-(S)ₙ-(C₁-C₁₂)alkylene-;
m is an integer from 0 to 20;
n is an integer from 1 to 4;
q is an integer from 2 to 3;
r is an integer from 0 to 1;
s is an integer from 1 to 2;
t is an integer from 0 to 1;
the sum of q + r is 3;
the sum of s + t is 2; and
b is an integer from 0 to 12.

4. The process for preparing the bi-layer coated steel substrate according to any of the claims 1-3, wherein
the organic precursor is selected from the group consisting of:
a compound of formula (VI) 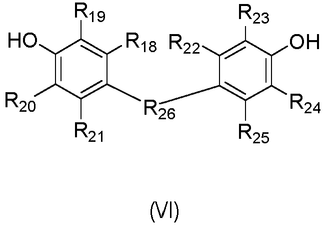 wherein:
R₁₈, R₁₉, R₂₀, R₂₁, R₂₂, R₂₃, R₂₄ and R₂₅ are independently selected from the group consisting of H, substituted or un-substituted (C₁-C₆)alkyl, (C₅-C₆)aryl, (C₂-C₁₄)alkenyl, and (C₂-C₁₄)alkyl-CH=CH- and substituted or un-substituted phenyl;
R₂₆ is selected from the group consisting of CR₂₇R₂₈, SO₂, a compound of formula (VII) 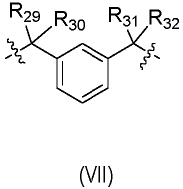
, a compound of formula (VIII) 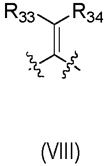
, a compound of formula (IX) 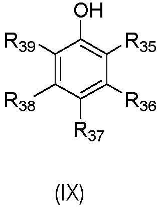
, a compound of formula (X) 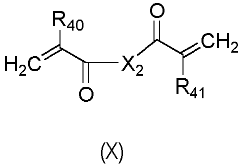
and a mixture thereof
wherein:
R₂₇ and R₂₈ are independently selected from the group consisting of H, substituted or un-substituted (C₁-C₆)alkyl, (C₅-C₆)aryl, (C₂-C₁₄)alkenyl, (C₂-C₁₄)alkyl-CH=CH-, and substituted or un-substituted phenyl;
R₂₉, R₃₀, R₃₁ and R₃₂ are independently selected from the group consisting of H, and substituted or un-substituted (C₁-C₆)alkyl, (C₅-C₆)aryl, (C₂-C₁₄)alkenyl, and (C₂-C₁₄)alkyl-CH=CH-;
R₃₃ and R₃₄ are independently selected from the group consisting of halogen and substituted or un-substituted (C₁-C₆)alkyl, (C₅-C₆)aryl, (C₂-C₁₄)alkenyl, and (C₂-C₁₄)alkyl-CH=CH-;
R₃₅, R₃₆, R₃₇, R₃₈ and R₃₉ are independently selected from the group consisting of a H, substituted or un-substituted (C₁-C₁₄)alkyl, (C₅-C₆)aryl, (C₂-C₁₄)alkenyl, and (C₂-C₁₄)alkyl-CH=CH, being at least one of R₃₅, R₃₆, R₃₇, R₃₈ and R₃₉ other than H;
R₄₀ and R₄₁ are independently selected from the group consisting of H and (C₁-C₆)alkyl;
X₂ is selected from the group consisting of a compound of formula (XI) 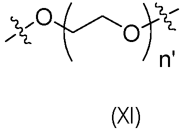
and a compound of formula (XII); 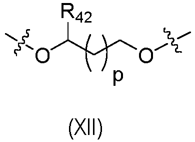
and a mixture thereof;
wherein:
R₄₂ is selected from the group consisting of H and (C₁-C₆)alkyl;
p is an integer from 1 to 8; and
n' is an integer from 1 to 6.

5. The process for preparing the bi-layer coated steel substrate according to any of the claims 1-4, wherein the acid catalyst is an inorganic acid independently selected from the group consisting of H₂SO₄, HCl, HNO₃, and a mixture thereof; and the (C₁-C₈)alcohol is independently selected from the group consisting of ethanol, butanol, propanol, and a mixture thereof.

6. The process for preparing the bi-layer coated steel substrate according to any of the claims 1-5, wherein the metal or semimetal alkoxide of step b1 and the metal alkoxide of step b2 are independently a compound of formula (XIII)
(OR⁴³)(OR⁴⁴)(OR⁴⁵)(OR⁴⁶)Z (XIII)
wherein:
each one of R⁴³, R⁴⁴, R⁴⁵ and R⁴⁶ are independently selected from the group consisting of substituted or un-substituted (C₁-C₁₄)alkyl, (C₅-C₆)aryl, (C₂-C₁₄)alkenyl and (C₂-C₁₄)alkynyl group; and
Z is selected from the group consisting of the metal and semimetal atoms.

7. The process for preparing the bi-layer coated steel substrate according to any of the claims 1-6, wherein the complexing agent is selected from the group consisting of acetyl acetone, methacrylic acid, acetic acid, isobutyric acid, bipyridine, and a mixture thereof.

8. The process for preparing the bi-layer coated steel substrate according to any of the claims 1-7, wherein the inorganic ceramic coating composition comprises one or more metal or semimetal oxide; metal or semimetal nitride; metal or semimetal carbide; metal or semimetal sulphide; metal or semimetal phosphide; metal or semimetal fluoride having a metal atom selected from the group consisting of Al, Ti, Zr, Y and semimetal selected from the group consisting of Si, Ge, B and a mixture thereof.

9. The process for preparing the bi-layer coated steel substrate according to any of the claims 1-8, wherein step a) is performed by atomic layer deposition.

10. The process for preparing the bi-layer coated steel substrate according to any of the claims 1-9, wherein step b) is performed by dipping the sol-gel coating composition over the coated steel substrate obtained in step a) at a deposition rate from 2 cm/min to 40 cm/min.

11. The process for preparing the bi-layer coated steel substrate according to any of the claims 1-10, wherein steel is selected from the group consisting of low-carbon steel, medium-carbon steel and high-carbon steel.

12. The process for preparing the bi-layer coated steel substrate according to any of the claims 1-11, wherein step c) is performed by submitting the coated substrate obtained in step b) at a temperature from 80°C to 220 °C for an appropriate period of time.

13. The process for preparing the bi-layer coated steel substrate according to any of the claims 1-12, wherein the process comprises repeating step a) until having a thickness of the inorganic ceramic layer deposited over the steel substrate from 50 nm to 4 µm.

14. The process for preparing the bi-layer coated steel substrate according to any of the claims 1-13, which comprises:
performing step a) by atomic layer deposition and repeating step a) until having a thickness of the inorganic ceramic layer deposited over the steel substrate from 50 nm to 300 nm;
and particularly; performing step a) by atomic layer deposition and repeating step a) until having a thickness of the inorganic ceramic layer deposited over the steel substrate from 100 nm to 200 nm.

15. A bi-layer coated steel substrate comprising an inner inorganic ceramic layer and an external sol-gel layer obtainable by the process as defined in any of the claims 1-14.

## Patentansprüche

1. Ein Verfahren zur Herstellung eines zweischichtig beschichteten Stahlsubstrats, umfassend:
eine innere anorganische Keramikschicht und eine äußere Sol-Gel-Schicht, wobei das Verfahren Folgendes umfasst:
a) zuerst, Abscheiden einer anorganischen keramischen Beschichtungszusammensetzung über einem Stahlsubstrat, um ein Stahlsubstrat zu erhalten, das mit einer anorganischen keramischen Monoschicht beschichtet ist;
b) zweitens, Abscheiden einer Sol-Gel-Beschichtungszusammensetzung, die aus der Gruppe ausgewählt ist, die aus Sol1, Sol2 und Sol3 besteht, über dem in Schritt a) erhaltenen beschichteten Stahlsubstrat, um das zweischichtig beschichtete Stahlsubstrat zu erhalten;
und c) drittens, Härten der in Schritt b) erhaltenen Beschichtung;
und wahlweise; das Verfahren umfasst ferner einen zusätzlichen Schritt d), welcher das Abscheiden von einer oder mehreren zusätzlichen Beschichtungen über dem in Schritt c) erhaltenen zweischichtig beschichteten Stahlsubstrat umfasst;
wobei:
die Sol1 eine Sol-Gel-Beschichtungszusammensetzung ist, die durch ein Verfahren b1) erhalten werden kann, das Folgendes umfasst:
b1') Herstellen einer ersten Mischung, die mindestens ein Alkoxid umfasst, das aus der Gruppe ausgewählt ist, die aus einem Metallalkoxid, einem Halbmetallalkoxid, einem Organosiliziumalkoxid und einer Mischung davon besteht; und wahlweise mindestens einen (C₁-C₈)-Alkohol;
b1") Herstellen einer zweiten Mischung mit einer wässrigen Lösung von mindestens einem sauren Katalysator mit einem pH-Wert von weniger als 5; und wahlweise: mindestens einem organischen Vorläufer, mindestens einem (C₁-C₈)-Alkohol, mindestens einem Polymerisationsinitiator oder einer Mischung davon; und
b1‴) Hinzufügen der in Schritt b1") erhaltenen zweiten Mischung zu der resultierenden Mischung aus Schritt b1'); und Rühren der resultierenden Mischung bei einer Temperatur von 15 °C bis 45 °C für einen angemessenen Zeitraum, um die Sol1 zu erhalten; und
b1ʺʺ) Aushärten der resultierenden Mischung durch Rühren bei einer Temperatur von 15 °C bis 30 °C für einen Zeitraum von 24 h bis 72 h;
die Sol2 eine Sol-Gel-Beschichtungszusammensetzung ist, die durch ein Verfahren b2) erhalten werden kann, das Folgendes umfasst:
b2') Herstellen einer Mischung, die mindestens ein Metallalkoxid; und wahlweise einen oder mehrere (C₁-C₈)-Alkohol(e) umfasst, unter einer inerten und trockenen Atmosphäre;
b2") Zugeben eines Komplexbildners zu der resultierenden, in Schritt b2') erhaltenen Mischung; und Rühren der resultierenden Mischung für einen angemessenen Zeitraum;
b2‴) Zugeben einer wässrigen Lösung von mindestens einem sauren Katalysator mit einem pH-Wert von weniger als 7 zu der resultierenden, in Schritt b2") erhaltenen Mischung und Rühren der resultierenden Mischung bei einer Temperatur von 15 °C bis 30 °C für einen angemessenen Zeitraum, um die Sol2 zu erhalten, und
b2ʺʺ) Aushärten der resultierenden Mischung durch Rühren bei einer Temperatur von 15 °C bis 30 °C für einen Zeitraum von 24 h bis 72 h;
und
die Sol3 eine Sol-Gel-Beschichtungszusammensetzung ist, die durch ein Verfahren erhalten werden kann, das das Mischen der in Schritt b1‴) oder Schritt b1"") erhaltenen Sol1 mit der in Schritt b2ʺʺ) oder Schritt b2ʺʺ) erhaltenen Sol2 und das Aushärten der resultierenden Mischung durch Rühren bei einer Temperatur von 15 °C bis 30 °C für einen Zeitraum von 24 h bis 72 h umfasst;
**dadurch gekennzeichnet, dass** Schritt a) unter Verwendung einer Technik durchgeführt wird, die aus der Gruppe ausgewählt ist, die aus Atomlagenabscheidung, chemischer Gasphasenabscheidung und physikalischer Gasphasenabscheidung besteht.

2. Das Verfahren zur Herstellung des zweischichtig beschichteten Stahlsubstrats nach Anspruch 1, wobei:
in Schritt b1') der mindestens eine (C₁-C₈)-Alkohol und das mindestens eine Organosiliziumalkoxid vorhanden sind und das Verfahren das Herstellen einer ersten Mischung durch Mischen von mindestens einem Metall- oder Halbmetallalkoxid oder einer Mischung davon; mindestens einem (C₁-C₈)-Alkohol; und mindestens einem Organosiliziumalkoxid umfasst; und
in Schritt b1") der mindestens eine organische Vorläufer, der eine oder die mehreren (C₁-C₈)-Alkohol(e) und der mindestens eine Polymerisationsinitiator vorhanden sind und das Verfahren das Herstellen einer zweiten Mischung durch Mischen einer wässrigen Lösung von mindestens einem sauren Katalysator mit einem pH-Wert von weniger als 5, mindestens einem organischen Vorläufer, mindestens einem (C₁-C₈)-Alkohol und mindestens einem Polymerisationsinitiator; und Rühren der resultierenden Mischung für einen angemessenen Zeitraum, um die Sol1 zu erhalten, umfasst.

3. Das Verfahren zur Herstellung des zweischichtig beschichteten Stahlsubstrats nach einem der Ansprüche 1 oder 2, wobei das Organosiliziumalkoxid ausgewählt ist aus der Gruppe bestehend aus:
einer Verbindung der Formel (I);
[R⁴]ₛ-Si(OR¹)ₜ(OR²)(OR³) (I)
einer Verbindung der Formel (II);
[R⁸-(CH₂)ₘ]-Si(OR⁵)_{q}R⁶ᵣ (II)
einer Verbindung der Formel (III);
(⁹RO)(¹⁰RO)(¹¹RO)Si-X₁-Si(OR¹²)(OR¹³)(OR¹⁴) (III)
einer Mischung aus mindestens einer Verbindung der Formel (I), worin R⁴ (C₁-C₄)-Alkyl ist, und mindestens einer Verbindung der Formel (I), worin R⁴ (C₂-C₁₄)-Alkenyl ist;
einer Mischung aus mindestens einer Verbindung der Formel (I) und mindestens einer Verbindung der Formel (II);
einer Mischung aus mindestens einer Verbindung der Formel (I) und mindestens einer Verbindung der Formel (III);
einer Mischung aus mindestens einer Verbindung der Formel (II) und mindestens einer Verbindung der Formel (III);
wobei:
jedes von R¹, R² und R³ unabhängig ausgewählt ist aus der Gruppe bestehend aus einer substituierten oder unsubstituierten (C₁-C₁₄)-Alkyl-, (C₅-C₆)-Aryl-, (C₂-C₁₄)-Alkenyl- und (C₂-C₁₄)-Alkinylgruppe;
R⁴ ausgewählt ist aus der Gruppe bestehend aus einem substituierten oder unsubstituierten (C₁-C₄)-Alkyl und einem substituierten oder unsubstituierten (C₂-C₁₄)-Alkenyl;
R⁵, R⁶, R⁷, R⁹, R¹⁰, R¹¹, R¹², R¹³ und R¹⁴ unabhängig voneinander ausgewählt sind aus der Gruppe bestehend aus einem substituierten oder unsubstituierten (C₁-C₁₄)-Alkyl, (C₅-C₆)-Aryl, (C₂-C₁₄)-Alkenyl und (C₂-C₁₄)-Alkyl-CH=CH-;
R⁸ ausgewählt ist aus der Gruppe bestehend aus H, -SH, substituiertem oder unsubstituiertem (C₁-C₁₂)-Alkyl, substituiertem oder unsubstituiertem (C₅-C₆)-Aryl, -(CF₂)_{b}-CF₃, -NR¹⁵R¹⁶, einer Verbindung der Formel (IV) 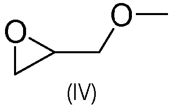
und einer Verbindung der Formel (V) 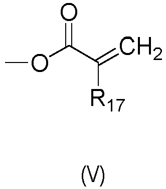
R¹⁵ und R¹⁶ unabhängig voneinander ausgewählt sind aus der Gruppe bestehend aus H, substituiertem oder unsubstituiertem (C₁-C₁₂)-Alkyl, -CO und substituiertem oder unsubstituiertem (C₅-C₆)-Aryl;
R¹⁷ ausgewählt ist aus der Gruppe bestehend aus H und substituiertem oder unsubstituiertem (C₁-C₁₂)-Alkyl;
X₁ ausgewählt ist aus der Gruppe bestehend aus substituiertem oder unsubstituiertem -(C₁-C₁₂)-Alkylen-, - (C₁-C₁₂)-Alkylen-NH-(C₁-C₁₂)-Alkylen- und -(C₁-C₁₂)-Alkylen-(S)ₙ-(C₁-C₁₂)-Alkylen-;
m eine ganze Zahl von 0 bis 20 ist;
n eine ganze Zahl von 1 bis 4 ist;
q eine ganze Zahl von 2 bis 3 ist;
r eine ganze Zahl von 0 bis 1 ist;
s eine ganze Zahl von 1 bis 2 ist;
t eine ganze Zahl von 0 bis 1 ist;
die Summe von q + r = 3 ist;
die Summe von s + t = 2 ist; und
b eine ganze Zahl von 0 bis 12 ist.

4. Das Verfahren zur Herstellung des zweischichtig beschichteten Stahlsubstrats nach einem der Ansprüche 1 bis 3, wobei der organische Vorläufer ausgewählt ist aus der Gruppe bestehend aus:
einer Verbindung der Formel (VI) 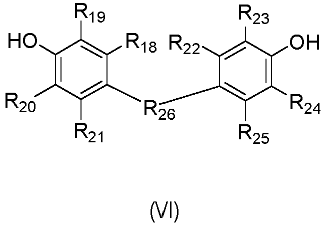 wobei:
R₁₈, R₁₉, R₂₀, R₂₁, R₂₂, R₂₃, R₂₄ und R₂₅ unabhängig voneinander ausgewählt sind aus der Gruppe bestehend aus H, substituiertem oder unsubstituiertem (C₁-C₆)-Alkyl, (C₅-C₆)-Aryl, (C₂-C₁₄)-Alkenyl und (C₂-C₁₄)-Alkyl-CH=CH- und substituiertem oder unsubstituiertem Phenyl;
R₂₆ ausgewählt ist aus der Gruppe bestehend aus CR₂₇R₂₈, SO₂, einer Verbindung der Formel (VII) 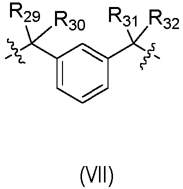
, einer Verbindung der Formel (VIII); 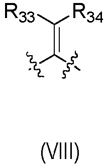
, einer Verbindung der Formel (IX); 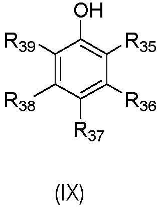
, einer Verbindung der Formel (X); 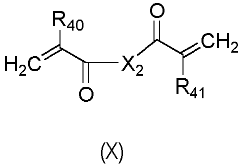
und einer Mischung davon
wobei:
R₂₇ und R₂₈ unabhängig voneinander ausgewählt sind aus der Gruppe bestehend aus H, substituiertem oder unsubstituiertem (C₁-C₆)-Alkyl, (C₅-C₆)-Aryl, (C₂-C₁₄)-Alkenyl, (C₂-C₁₄)-Alkyl-CH=CH- und substituiertem oder unsubstituiertem Phenyl;
R₂₉, R₃₀, R₃₁ und R₃₂ unabhängig voneinander ausgewählt sind aus der Gruppe bestehend aus H und substituiertem oder unsubstituiertem (C₁-C₆)-Alkyl, (C₅-C₆)-Aryl, (C₂-C₁₄)-Alkenyl und (C₂-C₁₄)-Alkyl-CH=CH-;
R₃₃ und R₃₄ unabhängig voneinander ausgewählt sind aus der Gruppe bestehend aus Halogen und
substituiertem oder unsubstituiertem (C₁-C₆)-Alkyl, (C₅-C₆)-Aryl, (C₂-C₁₄)-Alkenyl und (C₂-C₁₄)-Alkyl-CH=CH-; R₃₅, R₃₆, R₃₇, R₃₈ und R₃₉ unabhängig voneinander ausgewählt sind aus der Gruppe bestehend aus einem H, substituiertem oder unsubstituiertem (C₁-C₁₄)-Alkyl, (C₅-C₆)-Aryl, (C₂-C₁₄)-Alkenyl und (C₂-C₁₄)-Alkyl-CH=CH, wobei mindestens eines von R₃₅, R₃₆, R₃₇, R₃₈ und R₃₉ von H verschieden ist;
R₄₀ und R₄₁ unabhängig voneinander aus der Gruppe ausgewählt sind, die aus H und (C₁-C₆)-Alkyl besteht;
X₂ ausgewählt ist aus der Gruppe bestehend aus einer Verbindung der Formel (XI) 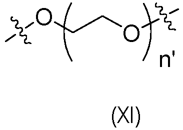
und einer Verbindung der Formel (XII); 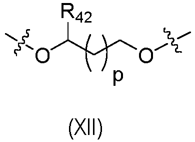
und einer Mischung davon;
wobei:
R₄₂ ausgewählt ist aus der Gruppe bestehend aus H und (C₁-C₆)-Alkyl;
p eine ganze Zahl von 1 bis 8 ist; und
n' eine ganze Zahl von 1 bis 6 ist.

5. Das Verfahren zur Herstellung des zweischichtig beschichteten Stahlsubstrats nach einem der Ansprüche 1 bis 4, wobei der Säurekatalysator eine anorganische Säure ist, die unabhängig aus der Gruppe ausgewählt ist, die aus H₂SO₄, HCl, HNO₃ und einer Mischung davon besteht; und der (C₁-C₈)-Alkohol unabhängig aus der Gruppe ausgewählt ist, die aus Ethanol, Butanol, Propanol und einer Mischung davon besteht.

6. Das Verfahren zur Herstellung des zweischichtig beschichteten Stahlsubstrats nach einem der Ansprüche 1 bis 5, wobei das Metall- oder Halbmetallalkoxid von Schritt b1 und das Metallalkoxid von Schritt b2 unabhängig voneinander eine Verbindung der Formel (XIII) sind
(OR⁴³)(OR⁴⁴)(OR⁴⁵)(OR⁴⁶)Z (XIII)
wobei:
jedes von R⁴³, R⁴⁴, R⁴⁵ und R⁴⁶ unabhängig voneinander ausgewählt ist aus der Gruppe bestehend aus substituierter oder unsubstituierter (C₁-C₁₄)-Alkyl-, (C₅-C₆)-Aryl-, (C₂-C₁₄)-Alkenyl- und (C₂-C₁₄)-Alkinylgruppe;
und
Z ausgewählt ist aus der Gruppe bestehend aus den Metall- und Halbmetallatomen.

7. Das Verfahren zur Herstellung des zweischichtig beschichteten Stahlsubstrats nach einem der Ansprüche 1 bis 6, wobei der Komplexbildner ausgewählt ist aus der Gruppe bestehend aus Acetylaceton, Methacrylsäure, Essigsäure, Isobuttersäure, Bipyridin und einer Mischung davon.

8. Das Verfahren zur Herstellung des zweischichtig beschichteten Stahlsubstrats nach einem der Ansprüche 1 bis 7, wobei die anorganische keramische Beschichtungszusammensetzung ein oder mehrere von Metall- oder Halbmetalloxid; Metall- oder Halbmetallnitrid; Metall- oder Halbmetallcarbid; Metall- oder Halbmetallsulfid; Metall- oder Halbmetallphosphid; Metall- oder Halbmetallfluorid mit einem Metallatom ausgewählt aus der Gruppe bestehend aus Al, Ti, Zr, Y und einem Halbmetall ausgewählt aus der Gruppe bestehend aus Si, Ge, B und einer Mischung davon umfasst.

9. Das Verfahren zur Herstellung des zweischichtig beschichteten Stahlsubstrats nach einem der Ansprüche 1 bis 8, wobei Schritt a) durch Atomlagenabscheidung durchgeführt wird.

10. Das Verfahren zur Herstellung des zweischichtig beschichteten Stahlsubstrats nach einem der Ansprüche 1 bis 9, wobei Schritt b) durch Eintauchen der Sol-Gel-Beschichtungszusammensetzung über das in Schritt a) erhaltene beschichtete Stahlsubstrat mit einer Abscheidungsrate von 2 cm/min bis 40 cm/min durchgeführt wird.

11. Das Verfahren zur Herstellung des zweischichtig beschichteten Stahlsubstrats nach einem der Ansprüche 1 bis 10, wobei der Stahl aus der Gruppe bestehend aus kohlenstoffarmem Stahl, mittelkohlenstoffhaltigem Stahl und kohlenstoffreichem Stahl ausgewählt ist.

12. Das Verfahren zur Herstellung des zweischichtig beschichteten Stahlsubstrats nach einem der Ansprüche 1 bis 11, wobei Schritt c) durchgeführt wird, indem das in Schritt b) erhaltene beschichtete Substrat einer Temperatur von 80 °C bis 220 °C für einen angemessenen Zeitraum ausgesetzt wird.

13. Das Verfahren zur Herstellung des zweischichtig beschichteten Stahlsubstrats nach einem der Ansprüche 1 bis 12, wobei das Verfahren das Wiederholen von Schritt a) umfasst, bis eine Dicke der anorganischen Keramikschicht, die über dem Stahlsubstrat abgeschieden ist, von 50 nm bis 4 µm erhalten ist.

14. Das Verfahren zur Herstellung des zweischichtig beschichteten Stahlsubstrats nach einem der Ansprüche 1 bis 13, das Folgendes umfasst:
durchführen von Schritt a) durch Atomlagenabscheidung und Wiederholen von Schritt a), bis eine Dicke der anorganischen Keramikschicht, die über dem Stahlsubstrat abgeschieden ist, von 50 nm bis 300 nm erhalten ist;
und insbesondere; Durchführen von Schritt a) durch Atomlagenabscheidung und Wiederholen von Schritt a), bis eine Dicke der anorganischen Keramikschicht, die über dem Stahlsubstrat abgeschieden ist, von 100 nm bis 200 nm erhalten ist.

15. Ein zweischichtig beschichtetes Stahlsubstrat umfassend eine innere anorganische Keramikschicht und eine äußere Sol-Gel-Schicht, das durch das Verfahren wie in einem der Ansprüche 1 bis 14 definiert erhalten werden kann.

## Revendications

1. Un procédé de préparation d'un substrat en acier revêtu bicouche comprenant :
une couche interne en céramique inorganique et une couche externe en sol-gel, dans lequel le procédé comprend :
a) premièrement, déposer une composition de revêtement céramique inorganique sur un substrat en acier pour obtenir un substrat en acier revêtu d'une monocouche céramique inorganique ;
b) deuxièmement, déposer une composition de revêtement sol-gel choisie dans le groupe constitué par sol1, sol2 et sol3 sur le substrat en acier revêtu obtenu à l'étape a) pour obtenir le substrat en acier revêtu bicouche ;
et c) troisièmement, durcir le revêtement obtenu à l'étape b) ;
et facultativement ; le procédé comprend en outre une étape supplémentaire d) qui comprend le dépôt d'un ou plusieurs revêtements supplémentaires sur le substrat en acier revêtu bicouche obtenu à l'étape c) ;
dans lequel :
la sol1 est une composition de revêtement sol-gel pouvant être obtenue par un procédé b1) qui comprend :
b1') préparer un premier mélange qui comprend au moins un alcoolate choisi dans le groupe constitué par un alcoolate métallique, un alcoolate semi-métallique, un alcoolate d'organo-silicium et un mélange de ceux-ci ; et facultativement au moins un alcool en (C₁-C₈) ;
b1") préparer un second mélange avec une solution aqueuse d'au moins un catalyseur acide ayant un pH inférieur à 5 ; et facultativement : au moins un précurseur organique, au moins un alcool en (C₁-C₈), au moins un initiateur de polymérisation ou un mélange de ceux-ci ; et
b1‴) ajouter le second mélange obtenu à l'étape b1") au mélange résultant de l'étape b1') ; et agiter le mélange résultant à une température allant de 15 °C à 45 °C pendant une période de temps appropriée pour obtenir la sol1 ; et
b1"") vieillir le mélange résultant par agitation à une température de 15 °C à 30 °C pendant une période de temps de 24 h à 72 h ;
la sol2 est une composition de revêtement sol-gel pouvant être obtenue par un procédé b2) qui comprend :
b2') préparer un mélange qui comprend au moins un alcoolate métallique ; et facultativement un ou plusieurs alcools en (C₁-C₈) sous une atmosphère inerte et sèche ;
b2") ajouter un agent complexant au mélange résultant obtenu à l'étape b2') ; et agiter le mélange résultant pendant une période de temps appropriée ;
b2‴) ajouter une solution aqueuse d'au moins un catalyseur acide ayant un pH inférieur à 7 au mélange résultant obtenu à l'étape b2") et agiter le mélange résultant à une température de 15 °C à 30 °C pendant une période de temps appropriée pour obtenir la sol2, et
b2"") vieillir le mélange résultant par agitation à une température de 15 °C à 30 °C pendant une période de temps de 24 h à 72 h ;
et
la sol3 est une composition de revêtement sol-gel pouvant être obtenue par un procédé qui comprend le mélange de la sol1 obtenue à l'étape b1‴) ou à l'étape b1"") avec la sol2 obtenue à l'étape b2‴) ou à l'étape b2""), et le vieillissement du mélange résultant en agitant à une température de 15 °C à 30 °C pendant une période de temps de 24 h à 72 h ;
**caractérisé en ce que** l'étape a) est réalisée en utilisant une technique choisie dans le groupe constitué par le dépôt de couches atomiques, le dépôt chimique en phase vapeur et le dépôt physique en phase vapeur.

2. Le procédé de préparation du substrat en acier revêtu bicouche selon la revendication 1, dans lequel :
à l'étape b1'), l'au moins un alcool en (C₁-C₈) et l'au moins un alcoolate d'organo-silicium sont présents et le procédé comprend la préparation d'un premier mélange en mélangeant au moins un alcoolate métallique ou semi-métallique ou un mélange de ceux-ci ; au moins un alcool en (C₁-C₈) ; et au moins un alcoolate d'organo-silicium ; et
à l'étape b1"), le au moins un précurseur organique, le ou les plusieurs alcools en (C₁-C₈) et le au moins un initiateur de polymérisation sont présents et le procédé comprend la préparation d'un second mélange en mélangeant une solution aqueuse d'au moins un catalyseur acide ayant un pH inférieur à 5, d'au moins un précurseur organique, d'au moins un alcool en (C₁-C₈) et d'au moins un initiateur de polymérisation ; et l'agitation du mélange résultant pendant une période de temps appropriée pour obtenir la sol1.

3. Le procédé de préparation du substrat en acier revêtu bicouche selon l'une quelconque des revendications 1 ou 2, dans lequel l'alcoolate d'organo-silicium est choisi dans le groupe constitué par :
un composé de formule (I) ;
[R⁴]ₛ-Si(OR¹)ₜ(OR²)(OR³) (I)
un composé de formule (II) ;
[R⁸-(CH₂)ₘ]-Si(OR⁵)_{q}R⁶ᵣ (II)
un composé de formule (III)
(⁹RO)(¹⁰RO)(¹¹RO)Si-X₁-Si(OR¹²)(OR¹³)(OR¹⁴) (III)
un mélange d'au moins un composé de formule (I), dans laquelle R⁴ est un alkyle en (C₁-C₄) et d'au moins un composé de formule (I), dans laquelle R⁴ est un alcényle en (C₂-C₁₄) ;
un mélange d'au moins un composé de formule (I) et d'au moins un composé de formule (II) ;
un mélange d'au moins un composé de formule (I) et d'au moins un composé de formule (III) ;
un mélange d'au moins un composé de formule (II) et d'au moins un composé de formule (III) ;
où :
chacun de R¹, R² et R³ sont indépendamment choisis dans le groupe constitué par un groupe alkyle en (C₁-C₁₄), aryle en (C₅-C₆), alcényle en (C₂-C₁₄) et alcynyle en (C₂-C₁₄) substitué ou non substitué ;
R⁴ est choisi dans le groupe constitué par un alkyle en (C₁-C₄) substitué ou non substitué et un alcényle en (C₂-C₁₄) substitué ou non substitué ;
R⁵, R⁶, R⁷, R⁹, R¹⁰, R¹¹, R¹², R¹³ et R¹⁴ sont indépendamment choisis dans le groupe constitué par un alkyle en (C₁-C₁₄), aryle en (C₅-C₆), alcényle en (C₂-C₁₄) et alkyle en (C₂-C₁₄)-CH =CH- substitués ou non substitués ;
R⁸ est choisi dans le groupe constitué par H, -SH, alkyle en (C₁-C₁₂) substitué ou non substitué, aryle en (C₅-C₆) substitué ou non substitué, -(CF₂)_{b}-CF₃, -NR¹⁵R¹⁶, un composé de formule (IV) 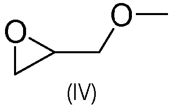
et un composé de formule (V) 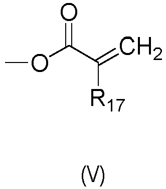
R¹⁵ et R¹⁶ sont indépendamment choisi dans le groupe constitué par H, alkyle en (C₁-C₁₂) substitué ou non substitué, -CO et aryle en (C₅-C₆) substitué ou non substitué ;
R¹⁷ est choisi dans le groupe constitué par H et alkyle en (C₁-C₁₂) substitué ou non substitué ;
X₁ est choisi dans le groupe constitué par -alkylène en (C₁-C₁₂)-, -alkylène en (C₁-C₁₂)-NH-alkylène en (C₁-C₁₂)- et -alkylène en (C₁-C₁₂)-(S)ₙ-alkylène en (C₁-C₁₂)- substitués ou non substitués ;
m est un nombre entier de 0 à 20 ;
n est un nombre entier de 1 à 4 ;
q est un nombre entier de 2 à 3 ;
r est un nombre entier de 0 à 1 ;
s est un nombre entier de 1 à 2 ;
t est un nombre entier de 0 à 1 ;
la somme de q + r est 3 ;
la somme de s + t est 2 ; et
b est un nombre entier de 0 à 12.

4. Le procédé de préparation du substrat en acier revêtu bicouche selon l'une quelconque des revendications 1 à 3, dans lequel le précurseur organique est choisi dans le groupe constitué par :
un composé de formule (VI) 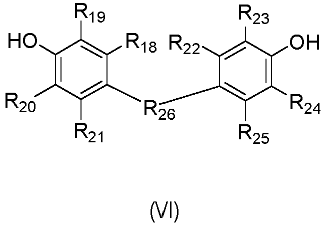 dans laquelle :
R₁₈, R₁₉, R₂₀, R₂₁, R₂₂, R₂₃, R₂₄ et R₂₅ sont indépendamment choisis dans le groupe constitué par H, alkyle en (C₁-C₆), aryle en (C₅-C₆), alcényle en (C₂-C₁₄) et alkyle en (C₂-C₁₄)-CH =CH- substitués ou non substitués et phényle substitué ou non substitué ;
R₂₆ est choisi dans le groupe constitué par CR₂₇R₂₈, SO₂, un composé de formule (VII) 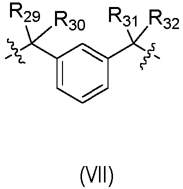
, un composé de formule (VIII) 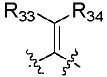 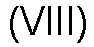
, un composé de formule (IX) 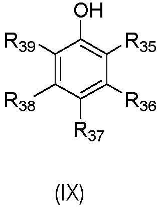
, un composé de formule (X) 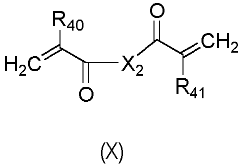
et un mélange de ceux-ci
où :
R₂₇ et R₂₈ sont indépendamment choisis dans le groupe constitué par H, alkyle en (C₁-C₆) substitué ou non substitué, aryle en (C₅-C₆), alcényle en (C₂-C₁₄), alkyle en (C₂-C₁₄)-CH=CH- et phényle substitué ou non substitué ;
R₂₉, R₃₀, R₃₁ et R₃₂ sont indépendamment choisis dans le groupe constitué par H et alkyle en (C₁-C₆), aryle en (C₅-C₆), alcényle en (C₂-C₁₄) et alkyle en (C₂-C₁₄)-CH=CH- substitués ou non substitués ;
R₃₃ et R₃₄ sont indépendamment choisis dans le groupe constitué par halogène et alkyle en (C₁-C₆), aryle en (C₅-C₆), alcényle en (C₂-C₁₄) et alkyle en (C₂-C₁₄)-CH=CH- substitués ou non substitués ;
R₃₅, R₃₆, R₃₇, R₃₈ et R₃₉ sont indépendamment choisis dans le groupe constitué par un H, alkyle en (C₁-C₁₄),
aryle en (C₅-C₆), alcényle en (C₂-C₁₄) et alkyle en (C₂-C₁₄)-CH=CH substitué ou non substitué, étant au moins l'un de R₃₅, R₃₆, R₃₇, R₃₈ et R₃₉ autre que H ;
R₄₀ et R₄₁ sont indépendamment choisis dans le groupe constitué par H et alkyle en (C₁-C₆) ;
X₂ est choisi dans le groupe constitué par un composé de formule (XI) 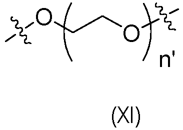
et un composé de formule (XII) ; 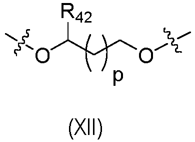
et un mélange de ceux-ci ;
où :
R₄₂ est choisi dans le groupe constitué par H et alkyle en (C₁-C₆) ;
p est un nombre entier de 1 à 8 ; et
n' est un nombre entier de 1 à 6.

5. Le procédé de préparation du substrat en acier revêtu bicouche selon l'une quelconque des revendications 1 à 4, dans lequel le catalyseur acide est un acide inorganique indépendamment choisi dans le groupe constitué par H₂SO₄, HCl, HNO₃ et un mélange de ceux-ci ; et l'alcool en (C₁-C₈) est indépendamment choisi dans le groupe constitué par l'éthanol, le butanol, le propanol et un mélange de ceux-ci.

6. Le procédé de préparation du substrat en acier revêtu bicouche selon l'une quelconque des revendications 1 à 5, dans lequel l'alcoolate métallique ou semi-métallique de l'étape b1 et l'alcoolate métallique de l'étape b2 sont indépendamment un composé de formule (XIII)
(OR⁴³)(OR⁴⁴)(OR⁴⁵)(OR⁴⁶)Z (XIII)
dans laquelle :
chacun de R⁴³, R⁴⁴, R⁴⁵ et R⁴⁶ sont indépendamment choisis dans le groupe constitué par un groupe alkyle en (C₁-C₁₄), aryle en (C₅-C₆), alcényle en (C₂-C₁₄) et alcynyle en (C₂-C₁₄) substitué ou non substitué ; et
Z est choisi dans le groupe constitué par les atomes métalliques et semi-métalliques.

7. Le procédé de préparation du substrat en acier revêtu bicouche selon l'une quelconque des revendications 1 à 6, dans lequel l'agent complexant est choisi dans le groupe constitué par l'acétylacétone, l'acide méthacrylique, l'acide acétique, l'acide isobutyrique, la bipyridine et un mélange de ceux-ci.

8. Le procédé de préparation du substrat en acier revêtu bicouche selon l'une quelconque des revendications 1 à 7, dans lequel la composition de revêtement céramique inorganique comprend un ou plusieurs parmi : oxyde métallique ou semi-métallique ; nitrure métallique ou semi-métallique ; carbure métallique ou semi-métallique ; sulfure métallique ou semi-métallique ; phosphure métallique ou semi-métallique ; fluorure métallique ou semi-métallique ayant un atome métallique choisi dans le groupe constitué par AI, Ti, Zr, Y et un semi-métal choisi dans le groupe constitué par Si, Ge, B et un mélange de ceux-ci.

9. Le procédé de préparation du substrat en acier revêtu bicouche selon l'une quelconque des revendications 1 à 8, dans lequel l'étape a) est réalisée par dépôt de couches atomiques.

10. Le procédé de préparation du substrat en acier revêtu bicouche selon l'une quelconque des revendications 1 à 9, dans lequel l'étape b) est réalisée en trempant la composition de revêtement sol-gel sur le substrat en acier revêtu obtenu à l'étape a) à une vitesse de dépôt allant de 2 cm/min à 40 cm/min.

11. Le procédé de préparation du substrat en acier revêtu bicouche selon l'une quelconque des revendications 1 à 10, dans lequel l'acier est choisi dans le groupe constitué par l'acier à faible teneur en carbone, l'acier à moyenne teneur en carbone et l'acier à haute teneur en carbone.

12. Le procédé de préparation du substrat en acier revêtu bicouche selon l'une quelconque des revendications 1 à 11, dans lequel l'étape c) est réalisée en soumettant le substrat revêtu obtenu à l'étape b) à une température allant de 80 °C à 220 °C pendant une période de temps appropriée.

13. Le procédé de préparation du substrat en acier revêtu bicouche selon l'une quelconque des revendications 1 à 12, dans lequel le procédé comprend la répétition de l'étape a) jusqu'à obtenir une épaisseur de la couche en céramique inorganique déposée sur le substrat en acier allant de 50 nm à 4 µm.

14. Le procédé de préparation du substrat en acier revêtu bicouche selon l'une quelconque des revendications 1 à 13, qui comprend :
réaliser l'étape a) par dépôt de couches atomiques et répéter l'étape a) jusqu'à obtenir une épaisseur de la couche en céramique inorganique déposée sur le substrat en acier allant de 50 nm à 300 nm ;
et en particulier ; réaliser l'étape a) par dépôt de couches atomiques et répéter l'étape a) jusqu'à obtenir une épaisseur de la couche en céramique inorganique déposée sur le substrat en acier allant de 100 nm à 200 nm.

15. Un substrat en acier revêtu bicouche comprenant une couche interne en céramique inorganique et une couche externe en sol-gel pouvant être obtenu par le procédé tel que défini dans l'une quelconque des revendications 1 à 14.
